Europäisches Patentamt

European Patent Office

Office européen des brevets

(19)

(11) Veröffentlichungsnummer : **0 156 042**
**B1**

(12) **EUROPÄISCHE PATENTSCHRIFT**

(45) Veröffentlichungstag der Patentschrift :
**15.03.89**

(21) Anmeldenummer : **84201869.9**

(22) Anmeldetag : **14.12.84**

(51) Int. Cl.⁴ : **H 01 F  7/20**

(54) Hochfrequenz-Spulenanordnung zum Erzeugen und/oder Empfangen von Wechselmagnetfeldern.

(30) Priorität : **30.12.83 DE 3347597**

(43) Veröffentlichungstag der Anmeldung :
**02.10.85 Patentblatt 85/40**

(45) Bekanntmachung des Hinweises auf die Patenterteilung : **15.03.89 Patentblatt 89/11**

(84) Benannte Vertragsstaaten :
**CH DE FR GB LI**

(56) Entgegenhaltungen :
**EP--A-- 0 021 535**
**EP--A-- 0 047 065**
**DE--A-- 2 604 301**
**DE--A-- 3 203 566**

(73) Patentinhaber : **Philips Patentverwaltung GmbH**
**Wendenstrasse 35 Postfach 10 51 49**
**D-2000 Hamburg 1 (DE)**
**DE**
**N.V. Philips' Gloeilampenfabrieken**
**Groenewoudseweg 1**
**NL-5621 BA Eindhoven (NL)**
**CH FR GB LI**

(72) Erfinder : **Röschmann, Peter**
**Steenbalken 13**
**D-2000 Hamburg 63 (DE)**
Erfinder : **Simon, Howard E.**
**18 River Drive**
**Monroe CT 06468 (US)**

(74) Vertreter : **Hartmann, Heinrich, Dipl.-Ing. et al**
**Philips Patentverwaltung GmbH Wendenstrasse 35**
**Postfach 10 51 49**
**D-2000 Hamburg 1 (DE)**

EP 0 156 042 B1

## Beschreibung

Die Erfindung bezieht sich auf eine Hochfrequenz-Spulenanordnung zum Erzeugen und/oder Empfangen wenigstens nahezu homogener Wechselmagnetfelder, insbesondere in Kernspinresonanzgeräten, die um einen im wesentlichen zylindrischen Untersuchungsraum angeordnet ist, mit wenigstens vier Leitersegmenten, die im wesentlichen parallel zur Längsmittelachse des Untersuchungsraumes und an dessen Umfang symmetrisch bezüglich wenigstens einer durch die Längsmittelachse verlaufenden Ebene ausgerichtet, über Verbindungsleitungen zu einer in sich geschlossenen Schleife verbunden und mit die Wechselmagnetfelder hervorrufenden, hochfrequenten Strömen beaufschlagbar sind.

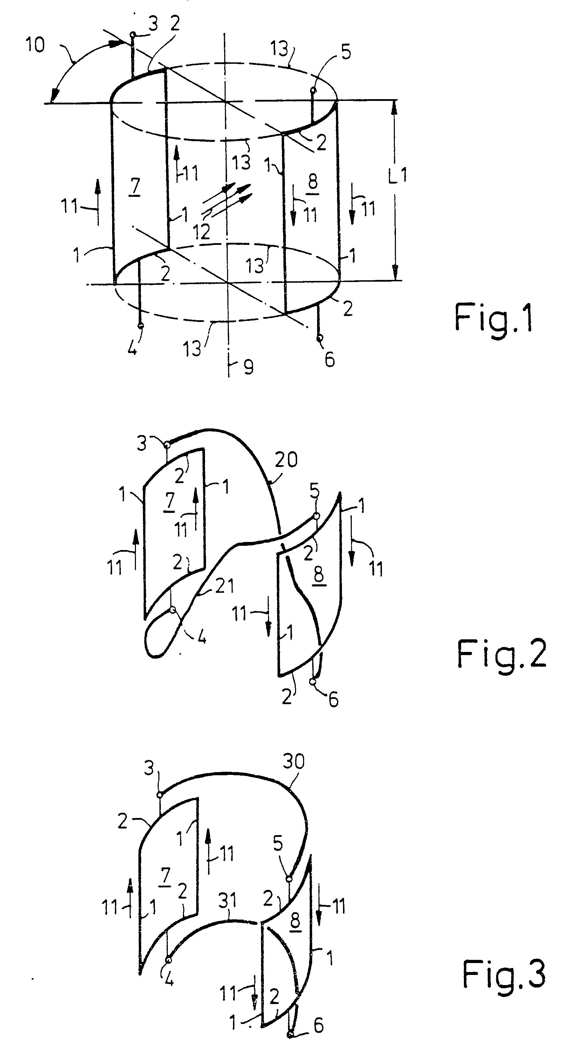

In der zur nach Artikel 54(3) EPÜ zum Stand der Technik zählenden, europäischen Patentanmeldung 83 201 449.2 (Veröffentlichungs-Nr. 0 107 238), insbesondere Fig. 2 mit zugehöriger Beschreibung, ist eine Sende-Meßspule vorgeschlagen worden, die bei einem Kernspintomographen um einen Untersuchungsraum für ein zu messendes Objekt angeordnet ist. Die vorgeschlagene Sende-Meßspule ist als Sattelspule ausgeführt und besteht aus zwei Spulenhälften. Zum Erregen der Spule werden die Spulenhälften in Parallelschaltung aus einer Hochfrequenzquelle gespeist. Jede der Spulenhälften besteht aus zwei Leitersegmenten, die in axialer Richtung der Sende-Meßspule verlaufen, sowie zwei in Umfangsrichtung der Sende-Meßspule verlaufenden Teilen. Alle vier sind zu einem Ring hintereinandergeschaltet und an den die Spulenanschlüsse bildenden Endpunkten dieser Hintereinanderschaltung über Speiseleitungen mit der Hochfrequenzquelle verbunden.

Die Spulenanschlüsse sind ferner mit einem Abstimmkondensator überbrückt. Spule und Abstimmkondensator bilden zusammen einen Parallelresonanzkreis, der bei der Frequenz der Hochfrequenzquelle auf Resonanz abgestimmt ist. Dadurch soll der Wirkungsgrad für die Abstrahlung der von der Hochfrequenzquelle gelieferten elektromagnetischen Energie von der Sende-Meßspule verbessert werden.

Mit zunehmender Frequenz der Hochfrequenzquelle muß gemäß der bekannten Schwingungsformel für Resonanzkreise die Größe des Abstimmkondensators bei Abstimmung auf Resonanz verringert werden. Die Frequenz, bei der sich die Sende-Meßspule allein, d. h. ohne zusätzlichen Abstimmkondensator in Resonanz befindet, wird als Eigenfrequenz der Spule bezeichnet. Durchweg weisen Sattelspulen eine Abwicklungslänge ihrer Leiter auf, die zwischen 15 und 20 % der Wellenlänge der Schwingung bei der Eigenfrequenz der Spule liegt. Der genaue Wert hängt von der Spulenform und von Streukapazitäten der Spule gegenüber umgebenden Leitern ab. Hochfrequente elektrische Ströme, die bei einem Betrieb im Bereich der Eigenfrequenz in der Spule fließen, weisen entlang der Abwicklungslänge der Spulenleiter erhebliche Phasenverschiebungen auf. Das von der Spule, insbesondere von ihren axial ausgerichteten Leitersegmenten, erzeugte hochfrequente Magnetfeld wird daher merklich inhomogen, wenn die Frequenz, mit der die Sattelspule betrieben wird, im Bereich der Eigenfrequenz liegt. Die Sattelspule liefert nur dann ein wenigstens nahezu homogenes hochfrequentes Magnetfeld, wenn die Frequenz der Hochfrequenzquelle wesentlich geringer ist als die Eigenfrequenz der Sattelspule.

Homogene hochfrequente Magnetfelder werden beispielsweise für die Kernspintomographie benötigt. Dabei wird der zu untersuchende Körper, vorzugsweise ein lebender Organismus, in ein statisches, homogenes Hauptmagnetfeld eingebracht. Die Atomkerne weisen aufgrund ihres Kernspins ein magnetisches Moment auf, das im Hauptmagnetfeld ausgerichtet wird. Die Stärke dieser Ausrichtung nimmt mit steigender magnetischer Induktion des Hauptmagnetfeldes zu.

Wirkt nun senkrecht zu den Feldlinien des Hauptmagnetfeldes ein magnetisches Wechselfeld auf die Atomkerne des zu untersuchenden Körpers ein, führen deren magnetische Momente eine Präzessionsbewegung aus, die sich aufschaukelt und zum Umklappen der magnetischen Momente in Gegenrichtung zum Hauptmagnetfeld führt. Quantenmechanisch betrachtet werden die magnetischen Momente durch Zufuhr von Energie aus dem Wechselmagnetfeld auf höhere Energiezustände angehoben, wofür eine bestimmte Energiemenge entsprechend einer bestimmten Frequenz des anregenden Wechselmagnetfeldes erforderlich ist. Diese Frequenz wird als Kernspinresonanzfrequenz $f0$ bezeichnet und ist mit der magnetischen Induktion $B0$ des Hauptmagnetfeldes über die Gleichung (x ist das Multiplikationszeichen)

$$f0 = gxB0$$

verknüpft. Dabei ist $g$ das gyromagnetische Verhältnis, das von der Atomart abhängt und beispielsweise für Wasserstoff 42,58 MHz/T, für Phosphor 17,23 MHz/T und für Natrium 11,26 MHz/T beträgt. Mit entsprechend gewählten Frequenzen des Wechselmagnetfeldes können somit die einzelnen Atomarten selektiv angeregt und die von den Atomen nach Abschalten des Wechselmagnetfeldes ausgestrahlten Relaxationssignale beim Abklingen ihrer Anregung selektiv gemessen werden.

Es zeigt sich, daß die Bildqualität bei der Bildaufnahme nach dem Verfahren der Kernspintomographie mit Erhöhung der magnetischen Induktion des Hauptmagnetfeldes zunimmt, da damit die Zahl der ausgerichteten magnetischen Momente der Atomkerne proportional zunimmt. Damit erhöhen sich jedoch auch die Kernspinresonanzfrequenzen für die verschiedenen Atomarten. Die Hochfrequenz-Spulenanordnung (Sende-Meßspule), durch die das hochfrequente Wechselmagnetfeld im Untersuchungsraum erzeugt wird und die von den Atomkernen abgestrahlten Relaxationssignale empfangen werden, muß dann auch bei den höheren Frequenzen noch ein Magnetfeld erzeugen, dessen Homogenität den Anforderungen bei der Kernspintomographie genügt.

Es hat sich gezeigt, daß ausreichend homogene hochfrequente Wechselfelder mit Sattelspulen nur dann erzeugt werden können, wenn die Abwicklungslänge der Sattenspulenleiter höchstens etwa 1/12 der Wellenlänge bei der Frequenz der Spulenströme, d. h. bei der zu messenden Kernspinresonanzfrequenz beträgt. Da nun andererseits die Abwicklungslänge einer derartigen Sattelspule durch die Abmessungen des zu untersuchenden Körpers bestimmt wird, lassen sich mit Sattelspulen homogene Wechselmagnetfelder nur bis zu einer bestimmten Frequenz erzeugen. Beispielsweise beträgt bei Sattelspulen, die für Messungen am menschlichen Kopf dimensioniert sind und deren axiale Länge und Durchmesser ungefähr gleich sind, die Abwicklungslänge näherungsweise das Vierfache des Spulendurchmessers. Wird dieser auf ungefähr 30 cm festgelegt, ergibt sich als Obergrenze für die noch meßbare Kernspinresonanzfrequenz ein Wert von ungefähr 20 MHz. Für die Messung der Kernspinresonanzen des Wasserstoffatoms darf dann die magnetische Induktion des Hauptmagnetfeldes maximal ungefähr 0,5 T betragen. Für eine befriedigende Bildqualität bei der Kernspintomographie und insbesondere auch für eine gute Auflösung bei der Kernspin-Spektroskopie am lebenden Organismus sind dagegen Werte für die magnetische Induktion des Hauptmagnetfeldes bis zu etwa 2 bis 2,5 T erwünscht.

Die im Vorstehenden am Beispiel der Kernspintomographie erläuterten Nachteile der bekannten Hochfrequenz-Spulenanordnung treten bei allen Anordnungen auf, in denen wenigstens nahezu homogene hochfrequente Wechselmagnetfelder in Raumbereichen erzeugt werden müssen, deren Abmessungen nicht mehr klein gegenüber der Wellenlänge des erzeugten hochfrequenten Feldes ist. Eine auf die Behebung dieser Nachteile gerichtete technische Lehre ist auf dem Gebiet der Kernspintomographie aus der vorveröffentlichten EP-A-0 047 065 bekannt.

Die Erfindung hat die Aufgabe, eine weitere Hochfrequenz-Spulenanordnung der eingangs genannten Art zu schaffen, die eine Erzeugung und einen Empfang wenigstens nahezu homogener hochfrequenter Wechselmagnetfelder auch über Raumbereiche ermöglichen, deren Abmessungen wenigstens annähernd die Größenordnung der Wellenlänge des hochfrequenten Magnetfeldes erreichen, deren Abmessungen somit einen wesentlichen Teil der Wellenlänge betragen.

Die Aufgabe wird bei einer Hochfrequenz-Spulenanordnung der eingangs genannten Art erfindungsgemäß dadurch gelöst, daß die von Strom gleichsinnig bezüglich der Längsmittelachse des Untersuchungsraumes zu beaufschlagenden Leitersegmente an einander benachbarten Enden über im wesentlichen in Umfangsrichtung des Untersuchungsraumes ausgerichtete Leiter Leitergruppen bildend miteinander verbunden sind, daß die Leitergruppen miteinander über an die in Umfangsrichtung ausgerichteten Leiter angeschlossene Verbindungsleitungen verbunden sind und daß die Längen der Verbindungsleitungen derart gewählt sind, daß sich in der Mitte jedes Leitersegments ein Amplitudenmaximum und auf jeder Verbindungsleitung wenigstens ein Amplitudenminimum der hochfrequenten elektrischen Ströme befindet.

Im Gegensatz zu der in der europäischen Patentanmeldung 83 201 449.2 vorgeschlagenen Spulenanordnung, bei der alle Leiterteile der Sattelspule gegenüber der Wellenlänge möglichst geringe Abmessungen aufweisen müssen, um Phasenverschiebungen der hochfrequenten Ströme in den Leitern über der gesamten Länge der Spule zu vermeiden, wird bei der erfindungsgemäßen Hochfrequenz-Spulenanordnung gerade diese Phasenverschiebung gezielt ausgenutzt, um in den einzelnen Leitersegmenten Ströme bestimmter Phase, d. h. bestimmter Richtung bezüglich der Längsmittelachse der Spulenanordnung hervorzurufen. Dabei wird die Tatsache ausgenutzt, daß die Ströme auf einer Leitung an zwei um ein ganzzahliges Vielfaches einer halben Wellenlänge voneinander entfernten Punkten übereinstimmen, sofern es sich um ein geradzahliges Vielfaches handelt, und betragsmäßig übereinstimmen mit entgegengesetztem Vorzeichen, wenn es sich um ein ungeradzahliges Vielfaches handelt. Es ist somit nicht erforderlich, alle zum hochfrequenten Wechselmagnetfeld beitragenden Ströme gleichphasig zu erzeugen, vielmehr genügt es, daß die Phasenverschiebungen zwischen diesen Strömen ein ganzzahliges Vielfaches von 180° entsprechend einem ganzzahligen Vielfachen einer halben Wellenlänge betragen. Damit lassen sich Spulenanordnungen verwirklichen, deren Abmessungen wenigstens nahezu die Größenordnung der Wellenlänge der abgestrahlten hochfrequenten Wechselmagnetfelder erreichen. Die Ströme in den Verbindungsleitungen tragen nicht zum Aufbau des hochfrequenten Wechselmagnetfeldes bei, so daß die Phasenverschiebungen der Ströme entlang der Verbindungsleitungen keinen Einfluß auf die Gestalt der Wechselmagnetfelder haben. Die Leitersegmente, die durch die Verbindungsleitungen gespeist werden, sind derart dimensioniert, daß die in ihnen fließenden Ströme bei der Betriebsfrequenz der Spulenanordnung nur geringe Phasenverschiebungen über der Länge der Leitersegmente erfahren, durch die die Homogenität des zu erzeugenden Wechselmagnetfeldes nicht merklich beeinträchtigt wird.

Bei erfindungsgemäßer Wahl der Längen der Verbindungsleitungen und Leitersegmente wird erreicht, daß sich die Spulenanordnung bei der Betriebsfrequenz in Resonanz befindet, so daß die Stromstärke in den Leitersegmenten und damit die magnetische Feldstärke der abgestrahlten Wechselmagnetfelder groß ist.

In der Anwendung auf die Kernspintomographie bedeutet das, daß mit der erfindungsgemäßen Spulenanordnung ein Untersuchungsraum umschlossen werden kann, dessen Abmessungen die Größenordnung der Wellenlänge bei der Betriebsfrequenz erreichen. Umgekehrt kann eine Spulenanordnung der Größe, wie sie durch die Abmessungen der zu untersuchenden Körper vorgegeben ist, bei höheren Frequenzen eingesetzt werden. Damit wird eine Steigerung der magnetischen Induktion B0 des Hauptmagnetfeldes von den bisher üblichen Werten unter 1 T auf Werte von 2 bis 2,5 T ermöglicht, was wiederum zu einer Verbesserung der Bildqualität bei der Kernspintomographie bzw. der Auflösung bei der Kernspin-Spektroskopie führt.

Darüber hinaus zeichnet sich die erfindungsgemäße Spulenanordnung durch einen einfachen Aufbau mit geringen Anforderungen an Fertigungstoleranzen aus.

Nach vorteilhaften Weiterbildungen der Erfindung steht das Verhältnis der Wellenwiderstände Z0, Z1 einer Leitergruppe und einer Verbindungsleitung zu deren Längen L0, L1 und Ausbreitungskonstanten β0, β1 in einer der Beziehungen

$$Z0/Z1 = |\tan (β0 \times L0/2) \times \tan (β1 \times L1/2)|$$

oder

$$Z0/Z1 = |\tan (β1 \times L1/2)/\tan (β0 \times L0/2)|$$

oder ist geringfügig größer. Die erste Beziehung gilt für eine Wahl der Länge einer Verbindungsleitung derart, daß sich auf ihr eine ungerade Zahl von Amplitudenminima ausbildet, die zweite Beziehung für den Fall, daß sich eine gerade Zahl Amplitudenminima ausbildet. Die Beziehungen berücksichtigen nur die Länge L0 einer Verbindungsleitung und die Länge L1 einer Leitergruppe, d. h. eines Leitersegments. Für eine genauere Rechnung wäre auch der Einfluß der in Umfangsrichtung ausgerichteten Leiter zu berücksichtigen, beispielsweise durch Erhöhen des für L1 eingesetzten Wertes um einen geringen Betrag, z. B. 10 %. Dadurch ergibt sich bei vorgegebenem Verhältnis Z0/Z1 ein etwas niedrigerer Wert für β0 und β1, d. h. ein etwas niedrigerer Wert für die Resonanzfrequenz.

Nach einer Weiterbildung der Erfindung weisen die Verbindungsleitungen elektrisch leitende Abschirmungen auf. Damit wird erreicht, daß nur die Leitersegmente ein hochfrequentes elektromagnetisches Wechselfeld abstrahlen, so daß dessen räumliche Gestalt nur von Stärke, Richtung und Phasenlage der hochfrequenten Ströme auf diesen Leitersegmenten abhängt. Die Ströme auf den Verbindungsleitungen beeinflussen das zu erzeugende Wechselmagnetfeld nicht und nehmen umgekehrt beim Empfang eines Wechselfeldes keine Energie aus diesem auf. Damit läßt sich die räumliche Anordnung der Verbindungsleitungen an der Spulenanordnung vereinfachen. Vorzugsweise sind die Verbindungsleitungen als Koaxialleitungen ausgebildet. Die Verbindungsleitungen sind dann besonders einfach und weisen konstante Wellenwiderstände auf, wodurch gute Übertragungseigenschaften und eine exakte Dimensionierbarkeit gewährleistet sind.

Nach einer weiteren Fortbildung der Erfindung umfaßt eine Leitergruppe je zwei benachbarte Leitersegmente. Dadurch werden einfach aufgebaute Leitergruppen erhalten, deren in Umfangsrichtung des Untersuchungsraumes ausgerichtete Leiter eine minimale Länge aufweisen.

Nach einer weiteren Fortbildung der Erfindung sind die Leitersegmente in zwei symmetrisch bezüglich einer durch die Längsmittelachse verlaufenden Ebene ausgerichteten Leitergruppen angeordnet. Mit einer derartigen Anordnung werden bevorzugt Wechselfelder erhalten, deren magnetische Feldlinien im Untersuchungsraum in der genannten Ebene senkrecht zur Längsmittelachse verlaufen und in der genannten Ebene sowie beiderseits davon in hohem Maße homogen sind.

Nach einer weiteren Fortbildung der Erfindung sind je zwei gleichsinnig vom Strom zu beaufschlagende Leitersegmente bezüglich des Untersuchungsraumes in einem Umfangswinkel von wenigstens annähernd 60° angeordnet. Dadurch wird im Untersuchungsraum ein besonders homogener Verlauf der magnetischen Feldlinien des hochfrequenten Wechselmagnetfeldes auch für eine minimale Anzahl von Leitersegmenten erreicht. Dies gilt insbesondere für den Fall, in dem lediglich zwei Leitergruppen mit je zwei Leitersegmenten vorhanden sind.

Nach einer weiteren Fortbildung der Erfindung sind die Leitersegmente von einer ihnen gegenüber elektrisch isoliert angebrachten, elektrisch leitenden und magnetisch durchlässigen Abschirmung umgeben.

Bei der Einstrahlung eines hochfrequenten magnetischen Wechselfeldes in einen zu messenden Körper beeinflussen dessen elektrische und dielektrische Eigenschaften entscheidend die Form und Stärke der Felder. Sie bestimmen das Eindringvermögen der hochfrequenten Wechselmagnetfelder in den zu untersuchenden Körper sowie die Resonanzfrequenz und die Resonanzgüte der Spulenanordnung. Darüber hinaus können insbesondere die hochfrequenten elektrischen Felder störende Wirkungen auf den zu messenden Körper ausüben.

Beispielsweise bei der Kernspintomographie an lebendem organischem Gewebe hat sich gezeigt, daß durch das Einbringen des zu messenden Körpers in die Spulenanordnung diese eine Resonanzgüteänderung und Resonanzfrequenzverschiebung erfährt. Bei einem vollständig ruhenden Körper entsteht dadurch eine Verringerung des Signal-Rauschverhältnisses und bei Bewegungen des zu messenden Körpers — auch Bewegungen im Inneren des zu messenden Körpers — je nach der dadurch vorhergerufenen Änderung der Resonanzgüte und Resonanzfrequenzverschiebung der Spulenanordnung ein zusätzliches Amplituden- bzw. Phasenrauschen im empfangenen Wechselmagnetfeld. Es zeigt sich, daß durch ein Abschirmen hochfrequenter elektrischer Wechselfelder von dem zu messenden Körper der nachteilige Einfluß der dielektrischen Eigenschaften des Körpers auf das Signal-Rauschverhältnis verringert werden kann.

Bei der erfindungsgemäßen Spulenanordnung bilden sich im Bereich der Leitersegmente Amplitudenmaxima der hochfrequenten elektrischen Ströme (« Strombäuche ») sowie Minima der zugehörenden elektrischen Spannung auf der Leitung (« Spannungsknoten ») aus. Demgemäß ist das von der erfindungsgemäßen Spulenanordnung an den Leitersegmenten angestrahlte hochfrequente elektrische Wechselfeld von vornherein gering. Um das noch verbliebene Feld in seiner Wirkung auf den zu messenden Körper weiter abzuschwächen, sind die Leitersegmente von der beschriebenen Abschirmung umgeben. Durch sie wird das verbliebene hochfrequente elektrische Wechselfeld von dem zu messenden Körper ferngehalten und somit die dielektrischen Verluste im Körper mit ihrem nachteiligen Einfluß auf die Bildqualität vermieden. Gleichzeitig wird durch die Abschirmung eine Gefährdung der zu messenden Körper durch elektrische Spannungen verhindert. Dies ist insbesondere bei einem Einsatz der erfindungsgemäßen Spulenanordnung auf dem Gebiet der Humanmedizin wichtig.

Nach einer weiteren Ausgestaltung der Erfindung umgibt je ein in sich geschlossener Teil der elektrisch leitenden und magnetisch durchlässigen Abschirmung die Leitersegmente je einer Leitergruppe gemeinsam. Dadurch sind die Leitersegmente einer Leitergruppe wirksam gegen ihre Umgebung abgeschirmt, insbesondere sind gegenseitige Beeinflussungen mit Verbindungsleitungen und anderen Leitergruppen ausgeschlossen.

Nach einer anderen Weiterbildung der Erfindung umfaßt die elektrisch leitende und magnetisch durchlässige Abschirmung einen dem Untersuchungsraum zugewandten und ihn umgebenden Innenschirm und einen ihm abgewandten Außenschirm und sind Innen- und Außenschirm aus im wesentlichen die Form von Zylindermantelsegmenten aufweisenden Teilen aufgebaut. Der Außenschirm unterbindet dabei ein Abstrahlen hochfrequenter Wechselfelder in die Umgebung der Spulenanordnung, während der Innenschirm zwar hochfrequente elektrische Wechselfelder vom Untersuchungsraum und von in ihm befindlichen, zu messenden Körpern fernhält, jedoch für hochfrequente magnetische Wechselfelder durchlässig ist, um deren Einstrahlen in zu messende Körper nicht zu beeinträchtigen.

Die Durchlässigkeit des Innenschirmes für hochfrequente magnetische Wechselfelder bei gleichzeitiger Abschirmung elektrischer Wechselfelder wird nach einer Weiterbildung der Erfindung dadurch erreicht, daß der Innenschirm im Bereich der Leitersegmente in Umfangsrichtung des Untersuchungsraumes verlaufende Schlitze aufweist.

Nach einer weiteren Fortbildung der Erfindung nimmt die Breite der Schlitze in Richtung der Längsmittelachse des Untersuchungsraumes von der Mitte der Spulenanordnung zu ihren Enden hin ab. Bei Abstimmung der erfindungsgemäßen Spulenanordnung auf Resonanz befinden sich in der Mitte der Länge der Leitersegmente Amplitudenmaxima der hochfrequenten Ströme (« Strombäuche ») entsprechend Minima der elektrischen Spannung (« Spannungsknoten ») der Spannung auf den Leitersegmenten und damit des von den Leitersegmenten abgestrahlten hochfrequenten elektrischen Feldes. Diese Spannung nimmt zu den Enden der Leitersegmente hin zu. Daher muß die Abschirmung des hochfrequenten elektrischen Feldes zu den Enden der Leitersegmente hin wirksamer werden, was mit der beschriebenen Abnahme der Schlitzbreiten zu den Enden der Leitersegmente hin erreicht wird.

Nach einer weiteren Fortbildung der Erfindung ist der Innenschirm im Bereich der durch die Längsmittelachse verlaufenden Ebene, bezüglich der die Leitergruppen symmetrisch ausgerichtet sind, und im Bereich der in Umfangsrichtung ausgerichteten Leiter geschlossen ausgebildet. Der Innenschirm ist dann in diesen Bereichen für hochfrequente elektrische und magnetische Wechselfelder undurchlässig. In den genannten Bereichen befinden sich somit keine Schlitze der vorstehend genannten Art oder ähnliche Durchbrüche. Der Raumbereich der erfindungsgemäßen Spulenanordnung, in dem die durch die Längsmittelachse verlaufende Ebene, bezüglich der die Leitergruppen symmetrisch ausgerichtet sind, den Innen- und auch den Außenschirm schneidet und der sich somit am Umfang des Untersuchungsraumes befindet, weist eine relativ geringe Dichte der Feldlinien des hochfrequenten magnetischen Wechselfeldes auf. Er wird daher auch als « neutrale Zone » bezeichnet. Die Ausgestaltung beispielsweise des Innenschirms in diesem Bereich hat einen geringeren Einfluß auf die Gestalt des hochfrequenten magnetischen Wechselfeldes als die Ausbildung beispielsweise des Innenschirms an einer anderen Stelle des Umfangs des Untersuchungsraumes. Insbesondere hat die Ausbildung des Innenschirms dort keinen wesentlichen Einfluß auf die Abstrahlung des magnetischen Wechselfeldes in den Untersuchungsraum. Durch die geschlossene Ausbildung des Innenschirms im Bereich der in Umfangsrichtung ausgerichteten Leiter wird ein Einfluß des hochfrequenten elektrischen und magnetischen Wechselfeldes dieser Leiter auf das Feld im Untersuchungsraum unterdrückt.

Nach einer weiteren Fortbildung der Erfindung sind die Verbindungsleitungen auf ihrer gesamten Länge in dem Bereich des Innenschirmes angeordnet, in dem dieser geschlossen ausgebildet ist. Dadurch wird eine Beeinflussung, d. h. Störung des hochfrequenten magnetischen Wechselfeldes durch die Verbindungsleitungen vermieden. Sofern die Verbindungsleitungen selbst eine Abschirmung aufweisen, ist diese an wenigstens einer Stelle mit dem Innen- und vorteilhaft auch mit dem Außenschirm elektrisch leitend verbunden, um eine gemeinsame Erdung zu bilden, durch die unkontrollierte hochfrequente Ströme in den Abschirmungen und damit Feldverzerrungen im Untersuchungsraum vermieden werden.

Nach einer weiteren Ausgestaltung der Erfindung sind Innen- und Außenschirm an den Enden der Spulenanordnung durch radial angeordnete Leiterstreifen miteinander verbunden. Durch diese Leiterstreifen werden die hochfrequenten elektrischen Felder an den Enden der Leitersegmente und den in Umfangsrichtung ausgerichteten Leitern gegenüber dem Untersuchungsraum und der Umgebung der Spulenanordnung abgeschirmt. Damit werden einerseits kapazitive Kopplungen mit dem zu messenden Körper und dadurch bedingte Resonanzverschiebungen und Verschlechterungen der Bildqualität bei der Kernspintomographie vermieden und andererseits eine Gefährdung des zu messenden Körpers durch die elektrischen Felder verhindert.

Nach einer weiteren Fortbildung der Erfindung ist die Abschirmung wenigstens teilweise schichtförmig ausgebildet. Die Abschirmung kann dann beispielsweise aus einem oder mehreren Blechen aus elektrisch leitendem Material aufgebaut sein oder mit einer Folie oder dergleichen gebildet werden. Eine derartige Ausgestaltung ist material- und gewichtssparend.

Nach einer weiteren Fortbildung der Erfindung ist die Abschirmung auf einem nichtleitenden Träger angeordnet. Dieser Träger kann beispielsweise aus Plexiglas oder einem anderen dielektrischen Material bestehen und bildet einerseits eine stabile Stützanordnung mit geringem Gewicht für die Abschirmung und andererseits eine galvanische Isolierung, beispielsweise zwischen der Abschirmung und dem Untersuchungsraum zum Schutz des zu messenden Körpers oder zwischen der Abschirmung und den Leitersegmenten zur Vermeidung elektrischer Überschläge. Die Abschirmung kann beispielsweise als Folie oder als aufgedampfte Schicht auf dem Träger angeordnet sein.

Nach einer weiteren Fortbildung der Erfindung ist die Abschirmung netzförmig ausgebildet. Sie ist in diesem Fall vorzugsweise aus einem Drahtgeflecht aufgebaut. Ein solches Drahtgeflecht ist mechanisch stabil, preiswert und leicht zu verarbeiten.

Die Abschirmung ist weiterhin vorzugsweise derart ausgebildet, daß sie für niederfrequente Wechselmagnetfelder im Frequenzbereich um einige KHz durchlässig bleibt. Derartige Magnetfelder, auch Gradientenmagnetfelder genannt, werden bei der Kernspintomographie dem Hauptmagnetfeld zur bilderzeugenden Abtastung des zu messenden Körpers überlagert. Diese Gradientenmagnetfelder werden von Gradientenspulen erzeugt, die außerhalb der Hochfrequenz-Spulenanordnung angeordnet sind. Der zeitliche Aufbau der Gradientenmagnetfelder im Untersuchungsraum wird dann durch Wirbelströme in den elektrisch leitenden Teilen der Hochfrequenz-Spulenanordnung verzögert. Wenn die Hochfrequenz-Spulenanordnung für die Gradientenmagnetfelder durchlässig sein soll, darf diese Verzögerung gegenüber der zeitlichen Veränderung der Gradientenmagnetfelder nicht merklich sein. Die Zeitkonstante für das Abklingen der durch die Gradientenmagnetfelder hervorgerufenen Wirbelströme muß dann wesentlich geringer sein als die Anstiegszeit der Gradientenmagnetfelder, im obigen Beispiel somit wesentlich unter einer msec liegen.

Dies wird nach einer anderen Ausgestaltung der Erfindung dadurch erreicht, daß die Abschirmung mit einer Schichtdicke von wenigen Skineffekt-Eindringtiefen bei der Frequenz des hochfrequenten Stromes ausgeführt ist. Beispielsweise kann die Schichtdicke drei Skineffekt-Eindringtiefen bei der Betriebsfrequenz der Spulenanordnung betragen. Der Einfluß der Schichtdicke auf die Leitfähigkeit für hochfrequente elektrische Ströme kann dann vernachlässigt werden, während für die niederfrequenten Wirbelströme, die durch die Gradientenmagnetfelder hervorgerufen werden, die Abschirmung einen hinreichend hohen Dämpfungswiderstand aufweist.

Auch die netzförmige Ausbildung der Abschirmung, insbesondere als Drahtgeflecht, ist vorteilhaft für ein rasches Abklingen der durch die Gradientenmagnetfelder hervorgerufenen Wirbelströme. Allerdings sinkt bei der Verwendung eines Drahtgeflechts infolge der niedrigeren effektiven Oberflächenleitfähigkeit im Vergleich zu einer in sich geschlossenen, elektrisch leitenden Schicht die Resonanzgüte der leeren Spulenanordnung, d. h. vor dem Einbringen des zu messenden Körpers. Diese Verminderung der Resonanzgüte ist jedoch gering im Vergleich zu der Verminderung der Resonanzgüte, die durch das Einbringen des zu messenden Körpers hervorgerufen wird, so daß bei Verwendung eines Drahtgeflechts für den Außenschirm nur eine vernachlässigbare Verringerung der effektiven Resonanzgüte auftritt, d. h. bei eingeführtem zu messendem Körper.

Nach einer anderen Ausgestaltung der Erfindung weisen die Leitersegmente und/oder die in Umfangsrichtung ausgerichteten Leiter die Gestalt dünnwandiger, leitender Rohre auf. Die Leitersegmente bilden mit den in Umfangsrichtung ausgerichteten Leitern gut leitende, geschlossene Leitungsrahmen, die einen starken Einfluß auf die Verzögerung der Gradientenfelder ausüben können. Durch Ausbilden der Leitersegmente in der Form dünnwandiger Rohre wird der Ohmsche Widerstand des Leitungsrahmens bei praktisch unveränderter Selbstinduktivität soweit erhöht, daß die Zeitkonstante für das Abklingen der im Leitungsrahmen hervorgerufenen Wirbelströme wesentlich kleiner wird als die Anstiegszeit der Gradientenmagnetfelder bei der Kernspintomographie. Damit sind verschlechternde Einflüsse der Leitersegmente beispielsweise auf die Bildqualität bei der Kernspintomographie vermieden.

Nach einer anderen Ausgestaltung der Erfindung sind Außen- und Innenschirm im wesentlichen konzentrisch bezüglich der Längsmittelachse des Untersuchungsraumes angeordnet.

Zwischen Außen- und Innenschirm befindet sich dann ein im wesentlichen hohlzylindrischer Zwischenraum, der eine abgeschirmte Anordnung der Leitersegmente, Verbindungsleitungen sowie etwaiger zusätzlicher Bauteile, beispielsweise zur Anpassung und Abstimmung der Spulenanordnung, gestattet. Der Durchmesser des Innenschirms wird dabei durch die Abmessungen des zu messenden Körpers, im Beispiel der Kernspintomographie auf dem Gebiet der Humanmedizin des menschlichen Körpers oder Teilen davon, bestimmt, während mit dem Durchmesser des Außenschirms der Platzbedarf der Leitersegmente und Verbindungsleitungen einerseits und der für die Spulenanordnung verfügbare Raum in einer das statische, homogene Hauptmagnetfeld erzeugenden Anordnung zu berücksichtigen ist.

Nach einer anderen Weiterbildung der Erfindung ist die Querschnittskontur des vom Innenschirm eingefaßten Untersuchungsraumes in einer zur Längsmittelachse senkrechten Ebene im wesentlichen elliptisch. Diese Ausbildung des Innenschirms ist insbesondere für die Kernspintomographie am menschlichen Körper wegen dessen im allgemeinen näherungsweise ellipsenförmigen Querschnitts vorteilhaft. Gegenüber einer kreisförmigen Querschnittskontur des Untersuchungsraumes in der zur Längsmittelachse senkrechten Ebene wird der Innenschirm jetzt im Bereich von Brust, Bauch und Rücken näher an den Patienten gelegt, so daß auch die Leitersegmente näher am Patienten, d. h. dem zu messenden Körper geführt werden können. Da bei einem hochfrequenten elektrischen Strom vorgegebener Amplitude in einem Leitersegment die Feldstärke des hochfrequenten magnetischen Wechselfeldes näherungsweise umgekehrt proportional zum senkrechten Abstand vom Leitersegment abnimmt, und in gleichem Maße auch eine Überkopplung der Relaxationssignale des zu messenden Körpers auf die Leitersegmente geringer wird, ergibt sich eine höhere Empfindlichkeit der Hochfrequenz-Spulenanordnung durch Verringern der Abstände zwischen den Leitersegmenten und dem zu messenden Körper, da die zur Anregung der Kernspinresonanz erforderliche Leistung des hochfrequenten magnetischen Wechselfeldes kleiner und das Signal-Rauschverhältnis größer wird. Außerdem vergrößert sich bei unverändertem Außenschirm der Abstand zwischen diesem und den Leitersegmenten, wodurch eine bessere Homogenität des hochfrequenten magnetischen Wechselfeldes im Untersuchungsraum erreicht wird.

Nach einer weiteren Fortbildung der Erfindung weisen Außen- und Innenschirm wenigstens nahezu gleiche Krümmungsradien auf. Durch diese Maßnahme wird eine fertigungstechnische Vereinfachung dahingehend erzielt, daß für Innen- und Außenschirm bzw. für die nichtleitenden Träger für Innen- und Außenschirm gleiche Bauteile, beispielsweise Rohrabschnitte mit gleichem Durchmesser verwendet werden können.

Nach einer anderen Ausgestaltung der Erfindung besteht die Abschirmung aus zwei in sich geschlossenen Teilen, die je einen Abschirmkäfig mit je einem Teil des Innen- und des Außenschirms bilden und deren Abstand zueinander senkrecht zur Längsmittelachse des Untersuchungsraumes veränderbar ist. Dadurch wird ein Verstellen der Größe des Untersuchungsraumes ermöglicht. Der Untersuchungsraum kann an die Abmessungen der jeweils zu untersuchenden Körper angepaßt werden. Damit lassen sich für jeden zu messenden Körper insbesondere die Abstände zwischen diesem und den Leitersegmenten im Sinne der zuvor genannten Verbesserung der Empfindlichkeit der Spulenanordnung einstellen.

Nach einer Weiterbildung der Erfindung sind die Abschirmkäfige senkrecht zur Längsmittelachse des Untersuchungsraumes gegeneinander verschiebbar. Beispielsweise sind die Abschirmkäfige in schienenartigen Führungen gehalten, durch die eine stets parallele Ausrichtung der Leitersegmente zueinander bei veränderlichem Abstand der Abschirmkäfige gewährleistet ist.

Nach einer anderen Weiterbildung der Erfindung sind die Abschirmkäfige um eine Achse, die in der Ebene, bezüglich der die Leitergruppen symmetrisch ausgerichtet sind, und zur Längsmittelachse parallel liegt, gegeneinander verschwenkbar. Dies kann beispielsweise dadurch erreicht werden, daß im Bereich der « neutralen Zone » die Abschirmkäfige durch ein Drehgelenk miteinander verbunden sind. Die Spulenanordnung läßt sich dann derart aufklappen, daß der zu messende Körper nicht mehr axial, d. h. in Richtung der Längsmittelachse, in den Untersuchungsraum eingeführt werden muß, sondern radial bezüglich der Längsmittelachse in den Untersuchungsraum eingebracht werden kann. Dadurch wird die Handhabung der Spulenanordnung insbesondere bei der Kernspintomographie am menschlichen Körper wesentlich vereinfacht.

Nach einer anderen Ausgestaltung der Erfindung sind die Verbindungsleitungen flexibel ausgeführt. Insbesondere sind die Verbindungsleitungen als flexible Koaxialleitungen ausgebildet. Dadurch wird einerseits der Aufbau der Spulenanordnung, d. h. die Verlegung der Verbindungsleitungen, vereinfacht. Andererseits wird dadurch eine einfache Leitungsverbindung auch zwischen Teilen der Spulenanordnung erhalten, deren Abstand zueinander veränderbar ist.

Nach einer anderen Ausgestaltung der Erfindung weisen die Leitersegmente bezüglich der Längsmittelachse des Untersuchungsraumes eine tonnenartige Krümmung auf. Bei zueinander paralleler Anordnung gerader Leitersegmente ist zu beobachten, daß die Feldstärke des hochfrequenten magnetischen Wechselfeldes von der Mitte der Leitersegmente zu ihren Enden hin abnimmt. Diese Abnahme kann dadurch kompensiert und somit die Homogenität des hochfrequenten magnetischen Wechselfeldes in Richtung der Längsmittelachse verbessert werden, daß die radialen Abstände der Leitersegmente zur Längsmittelachse des Untersuchungsraumes zu ihren Enden hin stetig verringert werden.

Außer der bereits beschriebenen Resonanzschwingung in der Spulenanordnung, bei der « Strombäuche » und entsprechend « Spannungsknoten » in der Mitte der Länge der Leitersegmente liegen, kann gegebenenfalls eine weitere Schwingung auf der Spulenanordnung angeregt werden, bei der sich « Spannungsbäuche » und entsprechend « Stromknoten » auf der Mitte der Länge der Leitersegmente befinden. Eine derartige Schwingungsform ist auf der Hochfrequenz-Spulenanordnung unerwünscht, da durch sie hochfrequente elektromagnetische Energie verbraucht und um die Leitersegmente ein hochfrequentes elektrisches Feld hervorgerufen wird. Zur Unterdrückung dieser Schwingungsform sind nach einer anderen Ausgestaltung der Erfindung zusätzliche Leitungsabschnitte mit je einem ersten Ende mit Anschlußstellen zwischen den Verbindungsleitungen und den in Umfangsrichtung des Untersuchungsraumes ausgerichteten Leitern verbunden. Durch diese zusätzlichen Leitungsabschnitte wird die Resonanzfrequenz der erwünschten Schwingungsform auf der Spulenanordnung kaum merklich beeinflußt, während die Resonanzfrequenz der unerwünschten Schwingungsform erheblich vermindert wird. Damit ist eine Verkopplung (Entartung) der beiden Schwingungsformen wegen des vergrößerten Frequenzabstandes zwischen ihren Resonanzfrequenzen unterbunden. Bei Anregung hochfrequenter elektrischer Ströme in den Leitersegmenten mit einer bestimmten Frequenz wird dann nur eine der beiden Schwingungsformen angeregt, nämlich die erwünschte mit « Strombäuchen » in den Leitersegmenten.

Nach einer weiteren Fortbildung der Erfindung sind die zusätzlichen Leitungsabschnitte als an ihrem zweiten Ende leerlaufende Koaxialleitungen ausgebildet. Durch den koaxialen Aufbau der zusätzlichen Leitungsabschnitte wird ein Einfluß der von ihnen erzeugten Felder auf die hochfrequenten magnetischen Wechselfelder im Untersuchungsraum vermieden. Bevorzugt können dazu die zusätzlichen Leitungsabschnitte parallel zu den in Umfangsrichtung ausgerichteten Leitern derart verlegt werden, daß sie gegenüber dem Untersuchungsraum durch einen in sich geschlossenen Teil des Innenschirms getrennt sind.

Nach einer anderen Ausbildung der Erfindung ist zwischen Innen- und Außenschirm im Bereich wenigstens einer Leitergruppe symmetrisch zu deren Leitersegmenten eine elektrisch leitende Koppelschleife im wesentlichen parallel zur Längsmittelachse des Untersuchungsraumes angeordnet, die mit einem ersten Ende mit dem Außenschirm verbunden ist und deren zweitem Ende hochfrequente elektromagnetische Energie zugeführt wird. Über die elektrisch leitende Koppelschleife wird die Spulenanordnung zu Resonanzschwingungen angeregt, deren Ströme das hochfrequente magnetische Wechselfeld im Untersuchungsraum hervorrufen. Umgekehrt können bei der Kernspintomographie die Relaxationssignale aus dem zu messenden Körper über die Hochfrequenz-Spulenanordnung in die Koppelschleife übertragen und von dieser zu einer Empfangseinrichtung weitergeleitet werden. Es ist dann zweckmäßigerweise eine Umschaltvorrichtung vorhanden, durch die die Koppelschleife abwechselnd mit einer Quelle zum Zuführen hochfrequenter elektromagnetischer Energie und mit einer Empfangseinrichtung zum Empfangen und Auswerten der Relaxationssignale verbunden wird. Es wird dann nur eine Koppelschleife für die Spulenanordnung benötigt.

Nach einer weiteren Ausgestaltung der Erfindung ist die Koppelschleife verformbar ausgeführt derart, daß die von der Koppelschleife und dem Außenschirm umgebene Fläche veränderbar ist. Dadurch ist in einfacher Weise eine Anpassung der Koppelschleife auf den Wellenwiderstand einer Anschlußleitung, über die die hochfrequente elektromagnetische Energie zu- und die Relaxationssignale abgeführt werden, ermöglicht. Bei einer derartigen Ausbildung der Koppelschleife wird auch der Einsatz kostspieliger Hochfrequenz-Hochspannungskondensatoren vermieden.

Nach einer weiteren Ausgestaltung der Erfindung ist parallel zur Längsmittelachse des Untersuchungsraumes und an dessen Umfang und gegebenenfalls im wesentlichen parallel zur Koppelschleife zu jeder Leitergruppe ein mit den in Umfangsrichtung ausgerichteten Leitern verbundener Hilfsleiter angeordnet. Durch eine derartige, parallel zur Koppelschleife an einer Leitergruppe angeordnete Hilfsleitung wird die Überkopplung der hochfrequenten elektromagnetischen Energie von der Koppelschleife in die Spulenanordnung verbessert. Aus Symmetriegründen erhalten alle Leitergruppen je einen entsprechenden, gleichartigen Hilfsleiter.

Nach einer weiteren Ausgestaltung der Erfindung wird die hochfrequente elektromagnetische Energie dem zweiten Ende der Koppelschleife über einen einstellbaren Kondensator zugeführt, durch den die Koppelschleife an den Wellenwiderstand der Anschlußleitung angepaßt wird. Die Koppelschleife kann dann starr und damit gegebenenfalls mechanisch stabiler ausgeführt werden.

Nach einer anderen Ausgestaltung der Erfindung weist wenigstens eine der Verbindungsleitungen eine Speiseanzapfung auf, über die der aus Verbindungsleitungen und Leitergruppen gebildeten Schleife hochfrequente elektromagnetische Energie zugeführt wird. Bei einer derartigen Einspeisung der hochfrequenten elektromagnetischen Energie können Koppelschleife und Hilfsleiter entfallen, so daß die Leiteranordnung besonders einfach ausgeführt ist. Die Speiseanzapfung ist bevorzugt an einer Stelle der Verbindungsleitung angeordnet, an der sich bei der erwünschten Schwingungsform bei der Betriebsfrequenz der Spulenanordnung ein « Spannungsbauch » ausbildet. Die Speiseanzapfung kann jedoch auch in einem bestimmten Abstand von diesem « Spannungsbauch » angeordnet sein. Durch diesen Abstand kann eine Wellenwiderstandsanpassung zwischen der an die Speiseanzapfung angeschlossenen Anschlußleitung und der Spulenanordnung vorgenommen werden. Eine derartige Wellenwiderstandsanpassung wird nach einer weiteren Fortbildung der Erfindung auch durch Zuführen der hochfrequenten elektromagnetischen Energie von der Anschlußleitung über einen einstellbaren Kondensator erreicht.

Für den Einsatz bei der Kernspintomographie ist es erforderlich, die Resonanzfrequenz der erfindungsgemäßen Spulenanordnung um einige Prozent abstimmen zu können. Dies resultiert vor allen daraus, daß sich beim Einbringen des zu messenden Körpers in die Spulenanordnung deren Resonanzfrequenz sowie die Belastung ändern, die die Spulenanordnung für die Anschlußleitung bildet. Auch durch die zur Anpassung der Belastung, d. h. des Wellenwiderstandes, durchzuführende Abstimmung beispielsweise der Fläche zwischen der Koppelschleife und dem Außenschirm oder der Kondensatoren, über die die hochfrequente elektromagnetische Energie zugeführt wird, kann sich die Resonanzfrequenz der Spulenanordnung verschieben. Ein Abstimmen der Resonanzfrequenz auf den durch die Induktion des Hauptmagnetfeldes bestimmten Wert für die zu messende Kernspinresonanz erfolgt nach einer anderen Ausgestaltung der Erfindung dadurch, daß das zweite Ende der Koppelschleife mit dem Außenschirm über einen verstellbaren Kondensator verbunden ist.

Ein weitaus größerer Frequenzabstimmbereich wird mit wenig erhöhtem Schaltungsaufwand dadurch erreicht, daß nach einer anderen Ausgestaltung der Erfindung die Verbindungsleitungen je eine Abstimmanzapfung aufweisen, an der sie über je einen verstellbaren Kondensator mit der Abschirmung verbunden sind. Die Abstimmanzapfungen sind bevorzugt an den Stellen der Verbindungsleitungen angeordnet, an denen sich bei der Resonanzfrequenz, d. h. der Betriebsfrequenz der Spulenanordnung « Spannungsbäuche » befinden. Um eine symmetrische Anordnung zu erhalten, ist jede Verbindungsleitung mit einer Abstimmanzapfung versehen.

Nach einer anderen Weiterbildung der Erfindung weisen die Verbindungsleitungen je eine Abstimmanzapfung auf, an der ein erstes Ende je einer koaxialen Abstimmleitung angeschlossen ist, die mit ihrem Leitermantel mit der Abschirmung verbunden ist und die eine verstellbare Länge aufweist. Für die Anordnung der Abstimmanzapfungen gilt das zuvor Gesagte. Durch Verwendung verstellbarer Koaxialleitungen, sogenannter « Hochfrequenz-Posaunen », kann der Einsatz verstellbarer Hochfrequenz-Hochspannungskondensatoren vermieden werden.

Eine besonders einfache und zuverlässige Abstimmvorrichtung ergibt sich nach einer weiteren Fortbildung der Erfindung dadurch, daß die Abstimmleitungen an ihren zweiten Enden einen Leerlauf bilden und daß innerhalb der Leitermäntel je ein in Leitungslängsrichtung verschiebbares Dielektrikum angeordnet ist. Derartige Abstimmleitungen sind besonders preiswert herstellbar und weisen keine beweglichen galvanischen Kontakte auf, wodurch eine sichere Funktion auch über längere Betriebszeiträume ohne Wartung gewährleistet ist.

Im folgenden werden anhand der Zeichnung einige Ausführungsbeispiele der Erfindung näher erläutert. Es zeigen

Fig. 1 eine schematische Darstellung für die Anordnung der Leitersegmente für ein Beispiel einer Spulenanordnung nach der Erfindung,

Fig. 2 eine schematische Darstellung für ein Beispiel einer Anordnung der Verbindungsleitungen bei dem Beispiel nach Fig. 1,

Fig. 3 eine schematische Darstellung für ein weiteres Beispiel einer Anordnung der Verbindungsleitungen bei dem Beispiel nach Fig. 1,

Fig. 4 Wellenwiderstände, Ausbreitungsgeschwindigkeiten, Spannungen und Ströme für Spulenanordnungen gemäß Fig. 2 und 3,

Fig. 5 eine schematische Darstellung eines Querschnitts durch eine erfindungsgemäße Spulenanordnung senkrecht zu ihrer Längsmittelachse,

Fig. 6 eine schematische Darstellung der Anordnung von Leitersegmenten, Innen- und Außenschirm bei einer Spulenanordnung nach der Erfindung,

Fig. 7 einen Querschnitt durch ein weiteres Beispiel für eine erfindungsgemäße Spulenanordnung senkrecht zu ihrer Längsmittelachse,

Fig. 8 eine Draufsicht auf die Spulenanordnung nach Fig. 7, teilweise aufgeschnitten,

Fig. 9 eine schematische Darstellung für ein weiteres Ausführungsbeispiel der Erfindung,

Fig. 10 eine schematische Darstellung eines anderen Ausführungsbeispiels der Erfindung im Längsschnitt,

Fig. 11 eine schematische Darstellung eines anderen Ausführungsbeispiels der Erfindung im Querschnitt senkrecht zur Längsmittelachse,

Fig. 12 eine schematische Darstellung eines weiteren Ausführungsbeispiels der Erfindung im Querschnitt senkrecht zur Längsmittelachse,

Fig. 13 eine schematische Darstellung eines Beispiels für eine andere Ausgestaltung einer erfindungsgemäßen Spulenanordnung im Querschnitt senkrecht zur Längsmittelachse,

Fig. 14 eine schematische Darstellung eines Beispiels für eine weitere Ausführungsform der Erfindung,

Fig. 15 eine schematische Darstellung für eine Abwandlung der Anordnung der Leitersegmente nach dem Ausführungsbeispiel nach Fig. 1,

Fig. 16 eine schematische Draufsicht auf ein weiteres Ausführungsbeispiel der Erfindung, teilweise aufgeschnitten,

Fig. 17 eine schematische Darstellung eines Teilschnittes durch ein anderes Ausführungsbeispiel der Erfindung,

Fig. 18 eine schematische Darstellung eines Beispiels für eine weitere Ausgestaltung der Erfindung,

Fig. 19 eine schematische Darstellung für eine Anordnung der Leitersegmente und Verbindungsleitungen in einem weiteren Ausführungsbeispiel der Erfindung,

Fig. 20 eine schematische Darstellung für eine Anordnung der Leitersegmente und Verbindungsleitungen in einem anderen Ausführungsbeispiel der Erfindung,

Fig. 21 eine schematische Darstellung für eine Abstimmleitung in einer erfindungsgemäßen Spulenanordnung.

In Fig. 1 ist schematisch die Anordnung der Leitersegmente 1 für ein einfaches Ausführungsbeispiel einer erfindungsgemäßen Spulenanordnung dargestellt. Je zwei Leitersegmente 1 sind an ihren benachbarten Enden durch in Umfangsrichtung ausgerichtete Leiter 2 miteinander und mit Anschlußstellen 3, 4, 5, 6 zu einer ersten Leitergruppe 7 und einer zweiten Leitergruppe 8 verbunden. Leitersegmente 1 und in Umfangsrichtung ausgerichtete Leiter 2 sind auf dem Umfang eines in diesem Beispiel kreiszylindrischen Untersuchungsraumes angeordnet, dessen Berandung durch die gestrichelten Linien 13 und dessen Längsmittelachse durch die strichpunktierte Linie 9 angedeutet ist. Die Leitersegmente 1 jeder der beiden Leitergruppen 7, 8 schließen bezüglich der Längsmittelachse 9 des Untersuchungsraumes einen Umfangswinkel 10 ein, der im beschriebenen Beispiel 60° beträgt.

Über die Anschlußstellen 3, 4, 5, 6 werden die Leitersegmente 1 mit hochfrequenten elektrischen Strömen beaufschlagt, deren Richtungen zu einem Bezugszeitpunkt, beispielsweise einem Zeitpunkt, zu dem sie ihren positiven Amplitudenwert erreichen, durch die Pfeile 11 wiedergegeben sind. Die Ströme in allen Leitersegmenten sind zu jedem Zeitpunkt jeweils betragsmäßig gleich. Im Untersuchungsraum wird durch sie ein wenigstens nahezu homogenes, hochfrequentes magnetisches Wechselfeld hervorgerufen, dessen Feldlinien im wesentlichen parallel zueinander verlaufen und dadurch ein Feldlinienbündel bilden, das senkrecht zur Längsmittelachse 9 des Untersuchungsraumes verläuft.

In Fig. 2 ist eine Möglichkeit zur Verbindung der Leitergruppen 7, 8 zu einer in sich geschlossenen Schleife dargestellt. Dabei verbindet eine erste Verbindungsleitung 20 die Anschlußstellen 3 und 6, eine zweite Verbindungsleitung 21 die Anschlußstellen 4 und 5 miteinander. Die Länge der Verbindungsleitungen 20, 21 ist derart gewählt, daß sich in der Mitte jedes Leitersegmentes 1 bei der Betriebsfrequenz der hochfrequenten elektrischen Ströme ein Amplitudenmaximum (« Strombauch ») und dazwischen in der Mitte jeder Verbindungsleitung 20, 21 ein Amplitudenminimum (« Stromknoten ») befindet. Zwischen den elektrischen Strömen der ersten Leitergruppe 7 einerseits und der zweiten Leitergruppe 8 andererseits besteht dann eine Phasenverschiebung von 180°. Durch die « über Kreuz » geführten Verbindungsleitungen 20, 21 erhält man dann in den Leitersegmenten 1 gerade die durch die Pfeile 11 angedeuteten Richtungen für die hochfrequenten elektrischen Ströme.

In Fig. 3 ist ein Schema für die Anordnung von Verbindungsleitungen für ein anderes Ausführungsbeispiel dargestellt. Eine dritte Verbindungsleitung 30 verbindet jetzt die Anschlußstellen 3 und 5 miteinander, während eine vierte Verbindungsleitung 31 die Anschlußstellen 4 und 6 miteinander verbindet. Die Verbindungsleitungen 30, 31 weisen jetzt eine derartige Länge auf, daß sich bei der Betriebsfrequenz der hochfrequenten elektrischen Ströme in der Mitte jedes Leitersegmentes 1 ein « Strombauch » und dazwischen in der Mitte jeder Verbindungsleitung 30, 31 zwei « Stromknoten » ausbilden. Bei unveränderter Betriebsfrequenz sind die Verbindungsleitungen 30, 31 länger als die Verbindungsleitungen 20, 21 aus Fig. 2. Zwischen den Strömen der ersten Leitergruppe 7 einerseits und der zweiten Leitergruppe 8 andererseits besteht dann eine Phasenverschiebung von 360°. Mit der Anordnung der Verbindungsleitungen 30, 31 ergeben sich wieder die durch die Pfeile 11 dargestellten Stromrichtungen. Eine derartige Vergrößerung der Länge der Verbindungsleitungen 30, 31 gegenüber den Verbindungsleitungen 20, 21 aus Fig. 2 kann angezeigt sein, wenn für eine erwünschte konstruktive Auslegung der Spulenanordnung die (geometrische) Länge der Verbindungsleitungen 20, 21 nicht ausreicht.

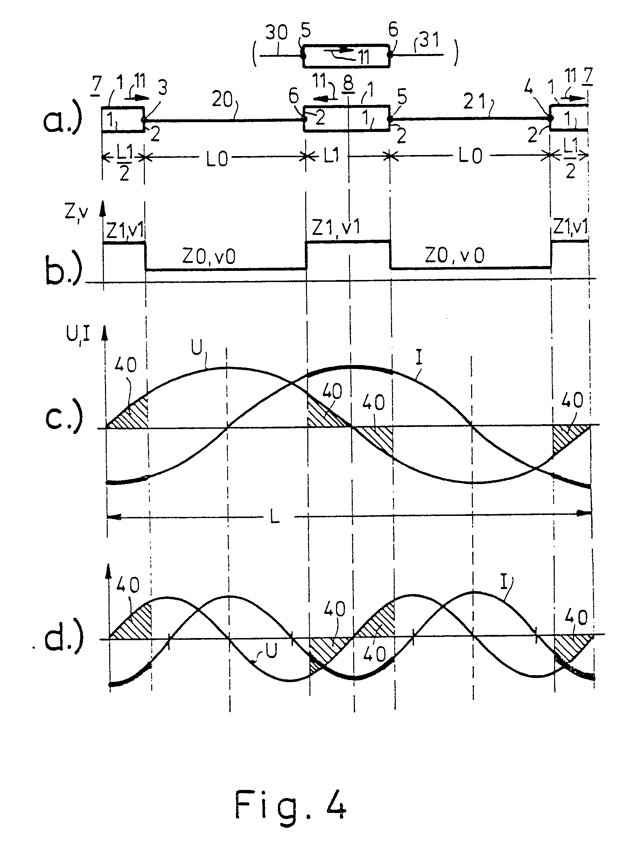

Fig. 4a zeigt eine schematische Darstellung der aus Leitergruppen 7, 8 und Verbindungsleitungen 20, 21 aufgebauten geschlossenen Schleife schematisch als langgestreckte Abwicklung. In einer Klammer sind darüber ergänzend die Änderungen skizziert, die sich demgegenüber in einer Spulenanordnung gemäß Fig. 3 ergeben. Wie auch in den übrigen Figuren, sind gleiche Teile stets mit identischen Bezugzeichen versehen.

Die Leitersegmente 1 weisen eine Länge L1 auf, während die Verbindungsleitungen 20, 21, 30, 31 eine Länge L0 aufweisen. Der Einfluß der in Umfangsrichtung ausgerichteten Leiter 2 ist beispielsweise in die Länge L1 der Leitersegmente 1 durch geringfügige Erhöhung der Werte für deren geometrische Länge eingerechnet.

Fig. 4b zeigt ein Beispiel für die Verläufe der für die Ausbreitung der hochfrequenten elektrischen Ströme auf den Leitersegmenten 1 und den Verbindungsleitungen 20, 21 bzw. 30, 31 maßgeblichen Wellenwiderstände Z und Ausbreitungsgeschwindigkeiten v entlang der Schleife. In dem gezeigten Beispiel weisen die Leitersegmente hohe Wellenwiderstände Z1 und hohe Ausbreitungsgeschwindigkeiten v1, die Verbindungsleitungen 20, 21 und 30, 31 dagegen niedrige Wellenwiderstände Z0 und niedrige Ausbreitungsgeschwindigkeiten v0 auf. Dadurch wird in vorteilhafter Weise erreicht, daß die Leitersegmente 1 bei einer durch die vorgegebene Baugröße der Spulenanordnung gegebenen geometrischen Länge eine minimale elektrische Länge aufweisen bzw. bei einer durch die maximal erlaubten Verzerrungen des hochfrequenten magnetischen Wechselfeldes vorgegebenen maximalen elektrischen Länge eine vergrößerte geometrische Länge aufweisen können, und daß die Verbindungsleitungen 20, 21, 30, 31, deren elektrische Längen durch die geforderte Verteilung von « Strombäuchen » und « Stromknoten » bei der Betriebsfrequenz vorgegeben sind, eine möglichst kurze Bauform erhalten.

Fig. 4c zeigt die Verläufe der hochfrequenten elektrischen Ströme und Spannungen entlang der Länge der in sich geschlossenen Schleife im Fall der Resonanz bei einer Anordnung gemäß Fig. 2. Die gesamte Länge der Schleife, gemessen über die Leitergruppen 7, 8 und die Verbindungsleitungen 20, 21, ist mit L bezeichnet. In den Mitten der Leitersegmente 1, d. h. in den Mitten der Leitergruppen 7, 8, befinden sich « Strombäuche » und entsprechend « Spannungsknoten ». Aufgrund der nicht verschwindenden elektrischen Länge der Leitersegmente 1 fällt die Stromstärke I zu den Enden der Leitersegmente 1 hin ab, jedoch ist dieser Abfall gemäß einer Sinusfunktion nur geringfügig. Die Spannung U auf den Leitersegmenten 1 steigt beiderseits der « Spannungsknoten » zu den Enden der Leitersegmente hin an, so daß sich auf den Leitersegmenten 1 Spannungen gemäß den Kurvenabschnitten in Fig. 4c ausbilden, die durch schräg schraffierte Flächen 40 hervorgehoben sind. Um den Abfall der Stromstärke I auf den Leitersegmenten 1 zu deren Enden hin, der eine Schwächung des hochfrequenten magnetischen Wechselfeldes bewirkt, in Grenzen zu halten, und um die Spannungen U an den Enden der Leitersegmente nicht zu groß werden zu lassen, soll die Länge der Leitersegmente L1 auf 1/8 der Wellenlänge begrenzt werden.

Für den Fall, daß die Leitergruppen 7, 8 mit Verbindungsleitungen 30, 31 gemäß Fig. 3 verbunden sind, ergibt sich über der Gesamtlänge L der Schleife eine Verteilung der Spannung U und der Stromstärke I gemäß Fig. 4d. Auf den Verbindungsleitungen 30, 31 befinden sich zwei « Stromknoten » und zwischen ihnen ein « Strombauch ». Während der Frequenzbereich, in dem die Anordnung gemäß Fig. 2 eingesetzt werden kann, bei praktisch ausgeführten Spulenanordnungen überwiegend durch die Länge der Verbindungsleitungen 20, 21 begrenzt wird, ist bei einer Spulenanordnung gemäß Fig. 3 mit den elektrisch längeren Verbindungsleitungen 30, 31 ein Betrieb bei höheren Frequenzen möglich. Begrenzungen des Frequenzbereiches entstehen hierbei vornehmlich durch die vorgegebene Länge der Leitersegmente 1.

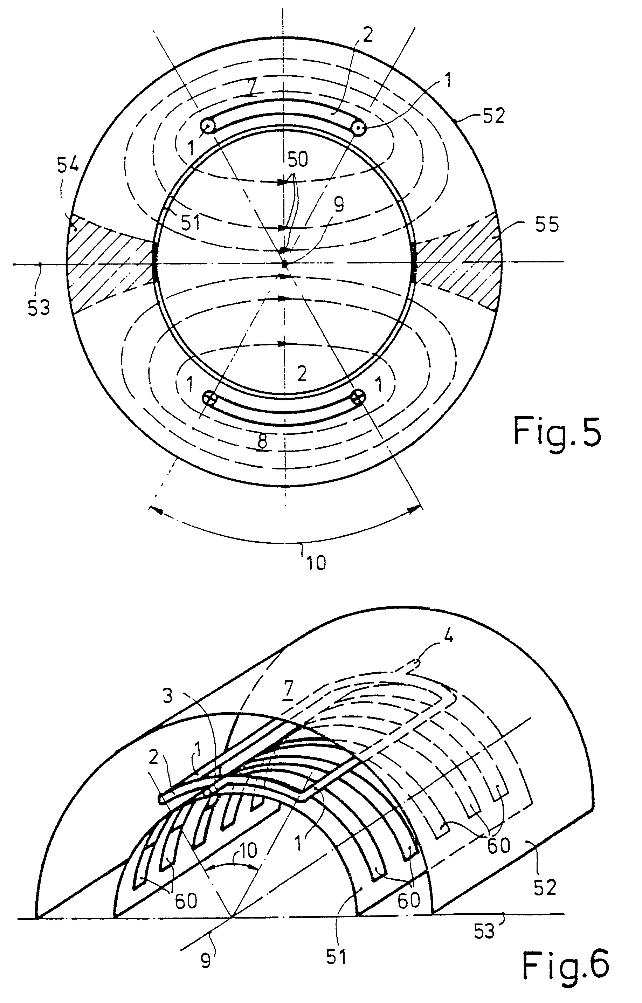

Fig. 5 zeigt einen Querschnitt durch ein weiteres Ausführungsbeispiel der erfindungsgemäßen Spulenanordnung senkrecht zur Längsmittelachse 9 des Untersuchungsraumes in schematischer Darstellung. Die Leitersegmente 1 der Leitergruppen 7 und 8 verlaufen senkrecht zur Zeichenebene und sind im Querschnitt dargestellt. In den zur ersten Leitergruppe 7 gehörenden Leitersegmenten 1 ist der hochfrequente elektrische Strom aus der Zeichenebene herausfließend dargestellt, in den zur zweiten Leitergruppe 8 gehörenden Leitersegmenten 1 in die Zeichenebene hineinfließend. Die gestrichelten Linien 50 zeigen mit den an ihnen eingezeichneten Pfeilen Verlauf und Richtung des durch die Ströme in den Leitersegmenten hervorgerufenen hochfrequenten magnetischen Wechselfeldes und entsprechen insoweit den Pfeilen 12 in Fig. 1. Die Leitersegmente 1 jeweils einer Leitergruppe 7, 8 sind in einem Umfangswinkel 10 bezüglich der Längsmittelachse 9 des Untersuchungsraumes angeordnet, der wieder 60° beträgt. Bei einer derartigen Bemessung des Winkels ergibt sich in der gezeigten Spulenanordnung mit vier Leitersegmenten ein besonders homogener Verlauf des hochfrequenten magnetischen Wechselfeldes im Untersuchungsraum.

Zwischen den Leitergruppen 7, 8 und dem Untersuchungsraum ist weiterhin ein diesen umschließender Innenschirm 51 aus elektrisch leitendem Material angeordnet, der den Untersuchungsraum gegen von den Leitergruppen 7, 8 hervorgerufene elektrische Felder abschirmt und der derart ausgebildet ist, daß in ihm von den hochfrequenten magnetischen Wechselfeldern keine nennenswerten Induktionsströme hervorgerufen werden, so daß er für die hochfrequenten magnetischen Wechselfelder durchlässig ist. Die gesamte Spulenanordnung ist von einem Außenschirm 52 umschlossen, der eine Ausbreitung von der Spulenanordnung erzeugter elektrischer und magnetischer Felder unterbindet.

Im Raum zwischen dem Innenschirm 51 und dem Außenschirm 52 sind im Bereich einer durch die Längsmittelachse 9 des Untersuchungsraumes verlaufenden Symmetrieebene 53, bezüglich der die Leitergruppen 7, 8 symmetrisch angeordnet sind, durch Schrägschraffur sogenannte neutrale Zonen 54, 55 bezeichnet. In diesen neutralen Zonen 54, 55 ist das hochfrequente magnetische Wechselfeld im Vergleich zu anderen Raumbereichen innerhalb des Außenschirms 52 relativ schwach, so daß Änderungen der Ausgestaltung der Spulenanordnung in diesen Bereichen nur geringe Einflüsse auf das hochfrequente magnetische Wechselfeld im Untersuchungsraum haben.

Fig. 6 zeigt in einer perspektivischen Darstellung schematisch die Anordnung der ersten Leitergruppe 7 zwischen Innenschirm 51 und Außenschirm 52. Die Leitersegmente 1 sind von der Abschirmung 51, 52 galvanisch isoliert, jedoch mit möglichst geringem Abstand am Innenschirm 51 angeordnet, da sie zum Erzielen eines möglichst starken hochfrequenten magnetischen Wechselfeldes möglichst nahe am Untersuchungsraum verlaufen sollen, der durch den Innenschirm 51 berandet wird. Zwischen den Leitersegmenten 1 und dem Außenschirm 52 ist dagegen ein größerer Abstand vorgesehen, was sich auf die Homogenität des hochfrequenten magnetischen Wechselfeldes im Untersuchungsraum günstig auswirkt. Innen- und Außenschirm 51, 52 sind schichtförmig ausgebildet. Der Innenschirm 51 weist im Bereich der Leitersegmente 1 Schlitze 60 auf, die in Umfangsrichtung des Untersuchungsraumes, d. h. senkrecht zu den Leitersegmenten 1 verlaufen. Der Außenschirm 52 ist dagegen geschlossen ausgebildet. Daher werden die hochfrequenten Felder der Leitersegmente 1 vom Außenschirm 52 vollständig gegenüber der Umgebung der Spulenanordnung abgeschirmt, während das hochfrequente magnetische Wechselfeld von den Leitersegmenten 1 durch die Schlitze 60 im Innenschirm 51 in den Untersuchungsraum durchgreift. Dagegen wird das hochfrequente elektrische Feld der Leitersegmente 1 durch den Innenschirm 51 vom Untersuchungsraum im wesentlichen ferngehalten.

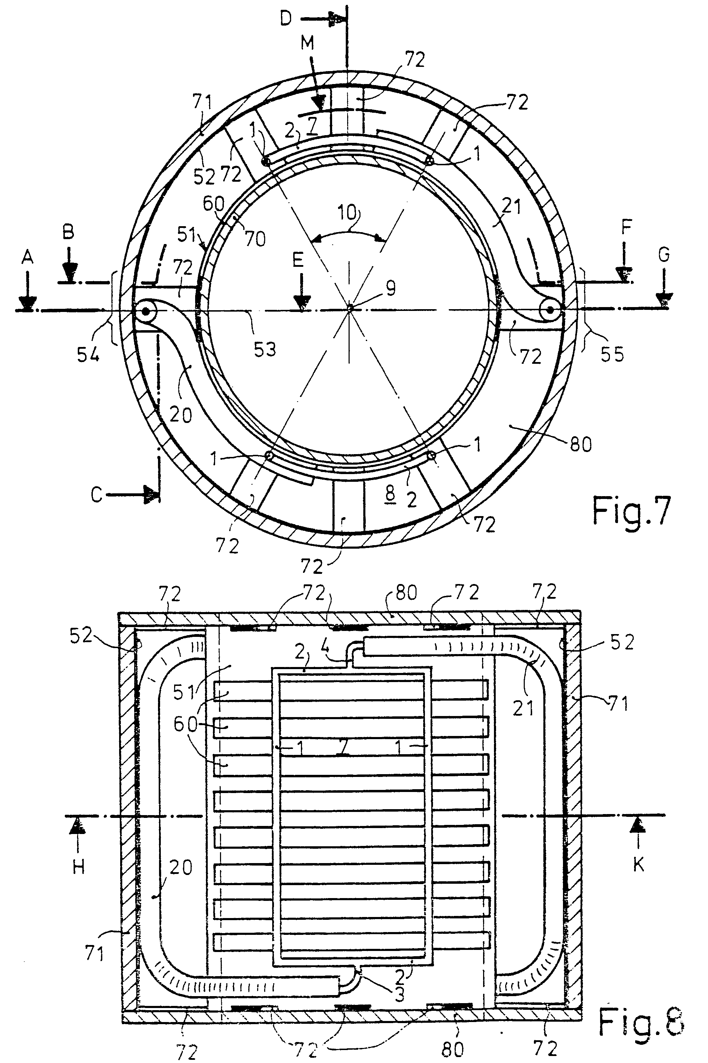

Fig. 7 zeigt einen Querschnitt durch ein weiteres Ausführungsbeispiel einer erfindungsgemäßen Spulenanordnung senkrecht zur Längsmittelachse 9 des Untersuchungsraumes in einer der Fig. 5 entsprechenden Darstellung. Bei dieser Anordnung ist der Innenschirm 51 zur mechanischen Stabilisierung und zur galvanischen Trennung gegenüber dem Untersuchungsraum auf einem kreiszylindrischen, dielektrischen Träger 70 angeordnet. Außerhalb des Innenschirms 51 befinden sich wie bei den bereits gezeigten Ausführungsbeispielen zwei Leitergruppen 7, 8 aus je zwei Leitersegmenten 1 und zwei in Umfangsrichtung des Untersuchungsraumes ausgerichteten Leitern 2. Die in der Schnittdarstellung nach Fig. 7 nicht sichtbaren Anschlußstellen 3, 4, 5, 6 der Leitergruppen sind gemäß der Anordnung nach Fig. 2 durch zwei Verbindungsleitungen 20, 21 miteinander verbunden, die, bei jeweils einer der Anschlußstellen 3, 4, 5, 6 beginnend, in Umfangsrichtung des Untersuchungsraumes am Innenschirm 51 entlang bis in die neutralen Zonen 53, 54 und dort parallel zur Längsmittelachse 9 des Untersuchungsraumes zum jeweils anderen Ende der Leitergruppen 7, 8 verlaufen. Diese gesamte Anordnung wird von dem in sich geschlossenen Außenschirm 52 umschlossen, der bei dem vorliegenden Ausführungsbeispiel an der Innenseite eines weiteren dielektrischen Trägers 71 angeordnet ist. Der dielektrische Träger 71 für den Außenschirm 52 ist ebenfalls kreiszylindrisch ausgebildet und wie der Träger 70 für den Innenschirm 51 konzentrisch zur Längsmittelachse 9 des Untersuchungsraumes ausgerichtet. Er dient der mechanischen Stabilisierung des Außenschirmes 52 und trennt diesen gleichzeitig galvanisch von der Umgebung der Spulenanordnung. Die Träger 70, 71 für Innen- und Außenschirm sind beispielsweise aus Plexiglas aufgebaut.

Innenschirm 51 und Außenschirm 52 sind weiterhin an den Enden der Spulenanordnung durch radial angeordnete Leiterstreifen 72 elektrisch leitend miteinander verbunden. Diese sind insbesondere im Bereich der in Umfangsrichtung ausgerichteten Leiter 2 sowie in den neutralen Zonen 54, 55 angeordnet. Sie schirmen damit das elektrische Feld ab, das auf den in Umfangsrichtung ausgerichteten Leitern 2 seine größte elektrische Feldstärke aufweist. Im Bereich der neutralen Zonen 54, 55 werden die dort befindlichen Verbindungsleitungen 20, 21 gegen die hochfrequenten Wechselfelder abgeschirmt, wofür auch der Innenschirm 51 in diesen Bereichen geschlossen ausgebildet ist. Damit werden vorzugweise Einflüsse der im Bereich der neutralen Zone verlaufenden Verbindungsleitungen 20, 21 auf die räumliche Gestalt des hochfrequenten magnetischen Wechselfeldes unterbunden, so daß beispielsweise eine ungleichförmige Verlegung der Verbindungsleitungen 20, 21 oder Veränderungen ihrer Lage die Homogenität des hochfrequenten magnetischen Wechselfeldes nicht beeinträchtigen.

Im Vergleich mit der Darstellung nach Fig. 2 sind die Verbindungsleitungen 20, 21 auf der entgegengesetzten Seite des Untersuchungsraumes geführt. Es leuchtet ein, daß die erste Verbindungsleitung 20 auch durch die neutrale Zone 55 und die zweite Verbindungsleitung 21 durch die neutrale Zone 54 geführt werden können, ohne die Verbindungen an den Anschlußstellen zu verändern.

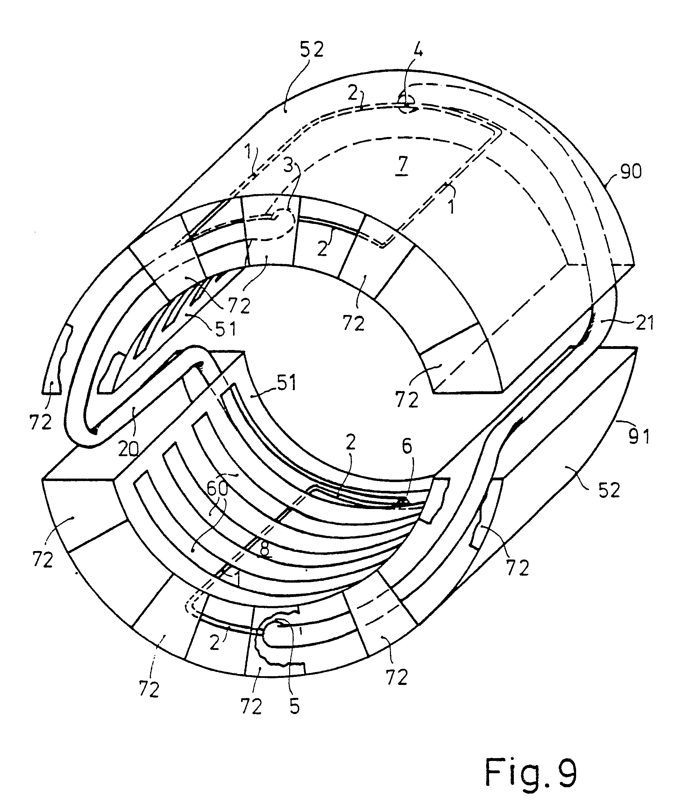

Fig. 8 zeigt eine Draufsicht auf die Spulenanordnung nach Fig. 7, die gemäß dem Schnittverlauf entlang der Linie B-M-F in Fig. 7 teilweise aufgeschnitten ist. Der Innenschirm 51 mit den in Umfangsrichtung ausgerichteten Schlitzen 60 sowie die darüber angeordnete erste Leitergruppe 7 sind in Draufsicht dargestellt, der Außenschirm 52 und der ihn umgebende Träger 71 sowie die im Bereich der in Umfangsrichtung ausgerichteten Leiter 2 angeordneten radialen Leiterstreifen 72 sind geschnitten dargestellt. Die Linie H-K deutet den Querschnitt durch die Spulenanordnung an, der in Fig. 7 dargestellt ist. Zusätzlich zu den bereits in Fig. 7 dargestellten und beschriebenen Teilen der Spulenanordnung sind in der Fig. 8 zwei isolierende Deckel 80 in teilweise geschnittener Darstellung zu erkennen, die die Spulenanordnung an ihren Enden galvanisch von der Umgebung trennen und mit den Trägern 70, 71 ein in sich geschlossenes Isoliergehäuse bilden.

Fig. 9 zeigt eine schematische perspektivische Darstellung einer Spulenanordnung, die weitgehend der in den Fig. 7 und 8 dargestellten Anordnung entspricht. Teile, die bereits aus den voraufgehenden Figuren bekannt sind, sind wieder mit gleichen Bezugszeichen versehen. Zur Vereinfachung der Darstellung sind die Träger 70, 71 sowiedie isolierenden Deckel 80 weggelassen, und es ist die Anzahl der Schlitze 60 im Innenschirm 51 reduziert worden. Innen- und Außenschirm 51, 52 sind im Bereich der neutralen Zonen 54, 55 unterbrochen dargestellt, um den Verlauf der Verbindungsleitungen 20, 21 in diesen Bereichen zu verdeutlichen. Die Verbindungsleitungen 20, 21 sind wie schon bei der Anordnung nach den Fig. 7 und 8 als Koaxialleitungen ausgeführt. In Abänderung des Ausführungsbeispiels der Fig. 7 und 8 ist es jedoch möglich, ohne merkliche Beeinträchtigung oder Veränderung der Gestalt des hochfrequenten magnetischen Wechselfeldes im Untersuchungsraum Innen- und Außenschirm 51, 52 wie in Fig. 9 dargestellt im Bereich der neutralen Zonen 54, 55 tatsächlich zu unterbrechen. Aus jeweils einer Hälfte des Innen- und des Außenschirms 51, 52 entstehen dann zwei in sich geschlossene und voneinander getrennte Abschirmkäfige 90, 91, die nur noch über die Verbindungsleitungen 20, 21 miteinander verbunden sind. Werden auch die gegebenenfalls Innen- und Außenschirm 51, 52 stützenden Träger 70, 71 im Bereich der neutralen Zonen 54, 55 aufgetrennt, und werden die Verbindungsleitungen 20, 21 als flexible Koaxialkabel ausgeführt, ergibt sich eine aus zwei in sich geschlossenen Teilen bestehende Spulenanordnung, bei der jeder Teil eine für sich abgeschirmte Leitergruppe umfaßt und bei der der Abstand der Teile gegeneinander veränderbar ist.

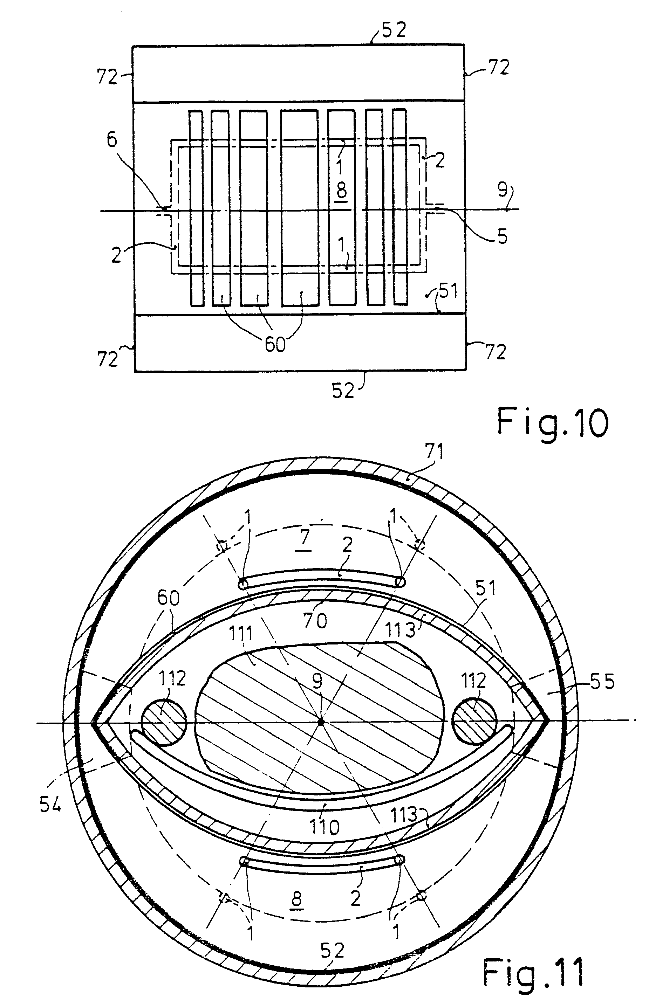

Fig. 10 zeigt in stark vereinfachter Darstellung einen Schnitt durch eine Spulenanordnung, die der in der Fig. 7 dargestellten weitgehend entspricht, entlang der Schnittlinie A-E-G gemäß Fig. 7. Im Gegensatz zu der dort dargestellten Spulenanordnung weist der Innenschirm 51 der Anordnung nach Fig. 10 Schlitze 60 auf, deren Breiten in Richtung der Längsmittelachse 9 des Untersuchungsraumes gemessen zu den Enden der Leitersegmente 1 hin abnehmen. Außerdem ist in Fig. 10 sowie in den Fig. 8 und 9 dargestellt, daß die in Umfangsrichtung ausgerichteten Leiter 2 sowie — siehe insbesondere Fig. 8. — die Verbindungsleitungen 20, 21 in Bereichen am Innenschirm 51 angeordnet sind, in denen dieser geschlossen ausgebildet ist.

Fig. 11 zeigt einen Querschnitt durch ein anderes Ausführungsbeispiel der erfindungsgemäßen Spulenanordnung senkrecht zur Längsmittelachse des Untersuchungsraumes entsprechend der Schnittlinie H-K der Fig. 8. Der Träger 71 mit dem Außenschirm 52 ist gegenüber den im Vorstehenden beschriebenen Ausführungsbeispielen unverändert. Der Träger 70 mit dem Innenschirm 51 besteht jetzt jedoch aus zwei zylindermantelförmigen Teilen 113, deren Krümmungsradien mit denen des Trägers 71 für den Außenschirm 52 übereinstimmen. Der von den Teilen 113 des Trägers 70 umschlossene Untersuchungsraum erhält somit eine im wesentlichen elliptische Querschnittsform. Im Vergleich dazu ist mit einer gestrichelten Kreislinie die Querschnittskontur eines konzentrischen Innenschirms, wie er in den Anordnungen nach den Fig. 7 bis 9 dargestellt ist, mit den zugehörigen Lagen der Leitersegmente 1 angedeutet. Bei der Ausgestaltung des Innenschirms nach dem vorliegenden Ausführungsbeispiel sind die Leitersegmente 1 näher zur Längsmittelachse des Untersuchungsraumes und damit näher zu dem zu messenden Körper gerückt. Die Empfindlichkeit der Spulenanordnung wird dadurch verbessert. Eine derartige Anordnung ist besonders vorteilhaft für die Messung am menschlichen Körper, dessen Querschnittskontur näherungsweise elliptisch ist. In Fig. 11 ist dazu der Querschnitt durch einen menschlichen Körper ungefähr in Brusthöhe angedeutet. Dabei bezeichnet 111 den Rumpfquerschnitt, während mit 112 die Armquerschnitte bezeichnet sind. Der zu messende menschliche Körper ist auf einem Patientenbett 110 abgestützt und wird liegend in die Spulenanordnung eingeschoben.

Wie bei den vorhergehenden Ausführungsbeispielen ist der Innenschirm 51 im übrigen im Bereich der Leitersegmente 1 mit in Umfangsrichtung ausgerichteten Schlitzen 60 versehen und im Bereich der neutralen Zonen 54, 55 geschlossen ausgebildet.

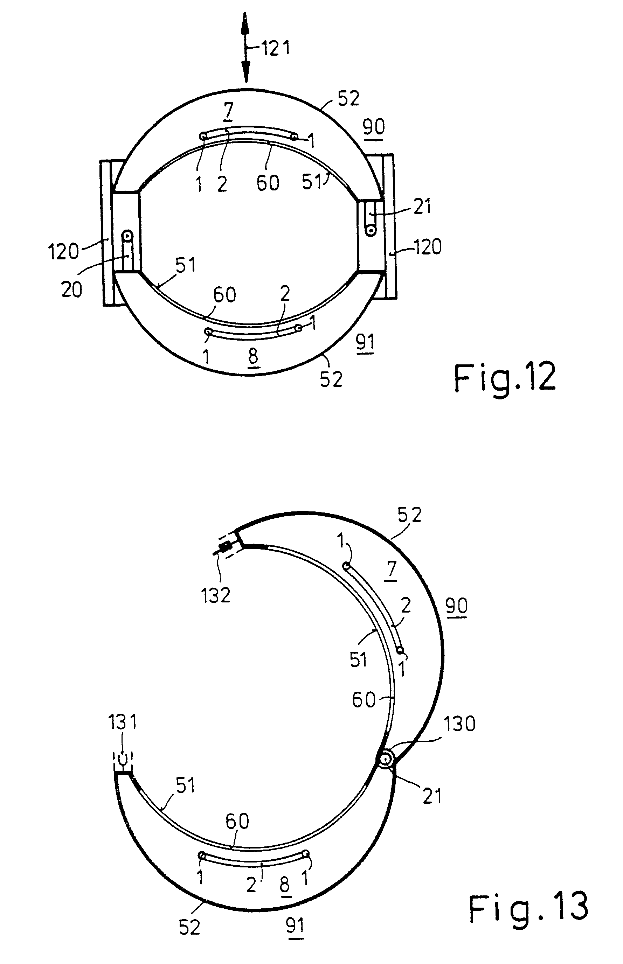

Fig. 12 zeigt in stark vereinfachter Darstellung ein Beispiel für eine weitere Ausgestaltung der Spulenanordnung nach Fig. 9 in einem Querschnitt senkrecht zur Längsmittelachse des Untersuchungsraumes gemäß der Linie H-K in Fig. 8. In dieser Anordnung sind die beiden in sich geschlossenen Abschirmkäfige 90, 91 zu erkennen, die durch die Verbindungsleitungen 20, 21 elektrisch miteinander verbunden sind. Die Abschirmkäfige 90, 91 sind im Bereich der neutralen Zonen der Spulenanordnung in Führungen 120 gelagert, die eine Verschiebung der Abschirmkäfige 90, 91 mit den Leitergruppen 7, 8 gegeneinander senkrecht zur Längsmittelachse 9 des Untersuchungsraumes ermöglichen. Die Verschiebungsrichtung ist durch den Doppelpfeil 121 angedeutet.

Fig. 13 zeigt ein weiteres Ausführungsbeispiel einer Spulenanordnung in weitgehend mit Fig. 12 identischer Ausführung und Darstellung. Die Abschirmkäfige 90, 91 sind jetzt in Abänderung der Anordnung nach Fig. 12 im Bereich der neutralen Zone 55 über ein Gelenk 130 schwenkbar miteinander verbunden. Dieses Gelenk ist vorzugsweise mit einer Hohlwelle ausgeführt, durch die die zweite Verbindungsleitung 21 geführt ist. In den Verlauf der ersten Verbindungsleitung 20 ist eine Hochfrequenzsteckverbindung eingefügt, die aus einem abgeschirmten Stecker 132 und einer abgeschirmten Buchse 131 besteht und beim Aufschwenken der Abschirmkäfige 90, 91 gegeneinander getrennt wird.

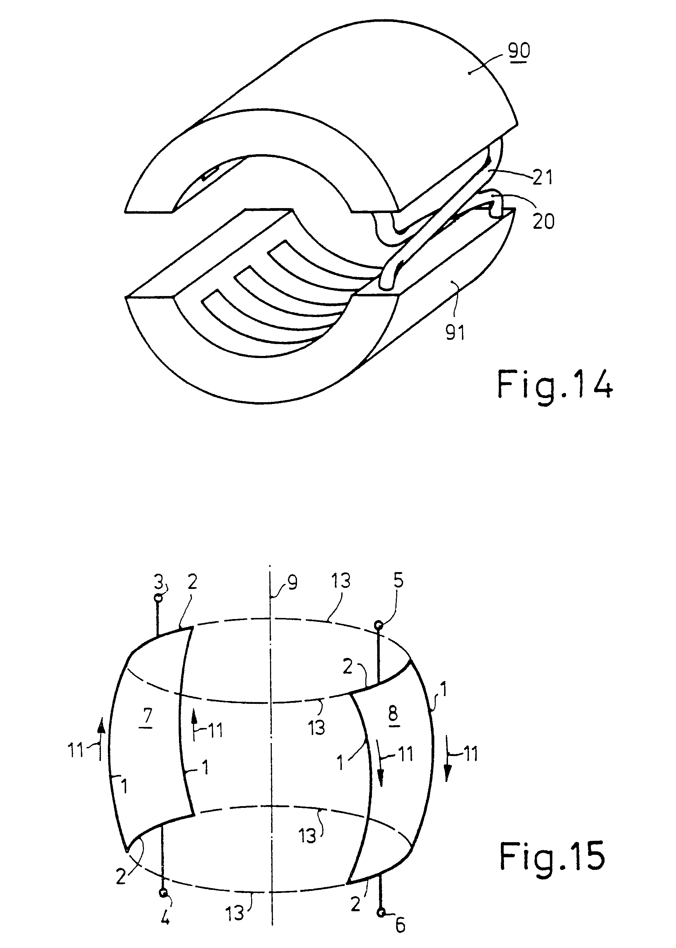

Fig. 14 zeigt eine schematische perspektivische Darstellung einer weiteren Abwandlung der Anordnung nach Fig. 13. Zur Vermeidung einer Hochfrequenzsteckverbindung gemäß Fig. 13 sind bei der Spulenanordnung nach Fig. 14 beide Verbindungsleitungen 20 und 21 durch eine einzige neutrale Zone geführt. Dadurch wird zwar die Symmetrie der Spulenanordnung geringfügig beeinträchtigt, durch Vermeiden der Hochfrequenzsteckverbindung jedoch ein teures und verschleißanfälliges Bauteil eingespart. Beide Verbindungsleitungen 20, 21 können beispielsweise gemeinsam in einer hohlen Gelenkwelle geführt sein.

Natürlich kann in einer Anordnung ähnlich der Fig. 13 in jede der Verbindungsleitungen 20, 21 eine Hochfrequenzsteckverbindung eingefügt sein. Die Abschirmkäfige 90, 91 sind dann völlig voneinander trennbar. Ein Vorteil einer derartigen Anordnung liegt insbesondere darin, daß beispielsweise zu einem Abschirmkäfig 91 mehrere unterschiedlich ausgebildete Abschirmkäfige 90, beispielsweise mit unterschiedlichen Anpaß- oder Abstimmelementen vorhanden sein können, die bei Bedarf wahlweise mit dem Abschirmkäfig 91 kombiniert werden können.

Fig. 15 zeigt eine Abwandlung der schematischen Darstellung nach Fig. 1, bei der die Leitersegmente 1 zur Verbesserung der Homogenität des hochfrequenten magnetischen Wechselfeldes im Untersuchungsraum in Richtung der Längsmittelachse 9 tonnenförmig gekrümmt sind. Im übrigen gilt das zu Fig. 1 Gesagte.

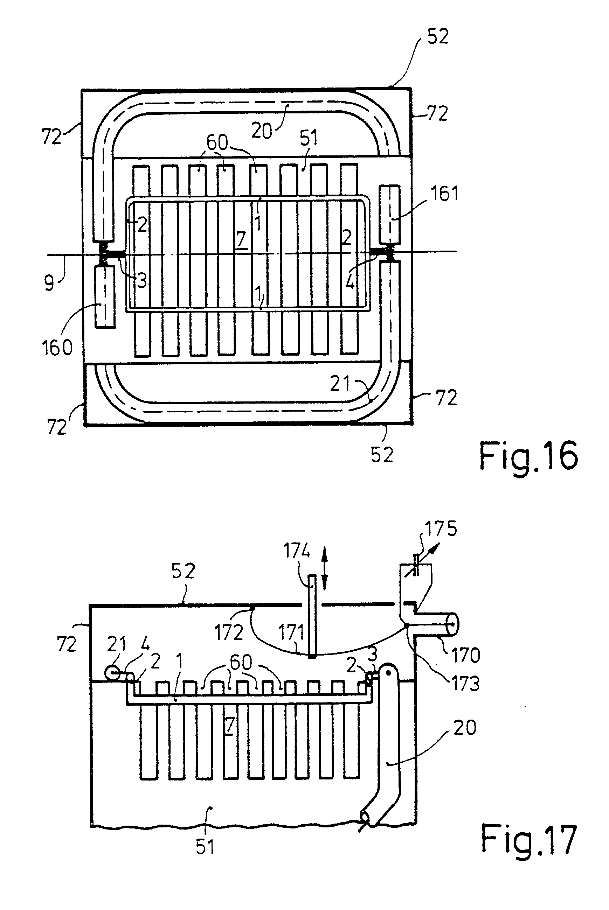

Fig. 16 zeigt eine vereinfachte Darstellung einer Spulenanordnung gemäß Fig. 8, d. h. in einer Schnittdarstellung entlang der Schnittlinie B-M-F aus Fig. 7. Zusätzlich zu der in Fig. 8 beschriebenen Anordnung sind an jeder der Anschlußstellen 3, 4, 5, 6 zusätzliche Leitungsabschnitte 160, 161 angeschlossen (die an die Anschlußstellen 5, 6 angeschlossenen Leitungsabschnitte sind nicht dargestellt), die als am Ende leerlaufende Koaxialleitungen ausgebildet sind und mit deren Hilfe unerwünschte Schwingungsformen auf der Spulenanordnung unterdrückt werden. Die zusätzlichen Leitungsabschnitte 160, 161 sind im Bereich der in Umfangsrichtung ausgerichteten Leiter 2 parallel zu diesen hinter einem geschlossenen Bereich des Innenschirms 51 angeordnet und somit durch diesen gegenüber dem Untersuchungsraum abgeschirmt. Als zusätzlicher Vorteil ergibt sich durch die beschriebene Anordnung der zusätzlichen Leitungsabschnitte 160, 161 eine verbesserte Symmetrie aller leitenden Teile im Bereich der in Umfangsrichtung ausgerichteten Leiter 2.

Fig. 17 zeigt schematisch einen Teilschnitt durch die Spulenanordnung nach Fig. 7 entlang der Schnittlinie C-M-D. Zusätzlich zu den in Fig. 7 und 8 beschriebenen Elementen weist die Anordnung nach Fig. 17 eine Koppelschleife 171 auf, die im Raum zwischen dem Innenschirm 51 und dem Außenschirm 52 von der Längmittelachse 9 des Untersuchungsraumes aus gesehen radial außerhalb der ersten Leitergruppe 7 angeordnet ist und die mit einem ersten Ende 172 mit dem Außenschirm 52 und mit einem zweiten Ende 173 mit einem Innenleiter einer koaxialen Anschlußleitung 170 verbunden ist, deren Außenleiter ebenfalls mit dem Außenschirm 52 verbunden ist. Über die koaxiale Anschlußleitung 170 kann der Spulenanordnung hochfrequente elektromagnetische Energie zugeführt bzw. von ihr abgeleitet werden, wobei die Koppelschleife 171 zur Überkopplung der Energie vom Innenleiter der koaxialen Anschlußleitung 170 auf die Leitersegmente 1 der ersten Leitergruppe 7 dient.

Die Überkopplung erfolgt bevorzugt über das magnetische Feld des in der Koppelschleife 171 fließenden und über die koaxiale Anschlußleitung 170 eingespeisten Stromes. Die Kopplung zwischen der Koppelschleife 171 und der Leitergruppe 7 kann durch Veränderung der von der Koppelschleife 171 und dem Außenschirm 52 umschlossenen Fläche eingestellt werden. Zur Einstellung der Fläche ist die Koppelschleife 171 mit einem biegsamen Leiter ausgeführt und an einem Stellglied 174 befestigt, durch das der Abstand zwischen der Koppelschleife 171 und dem Außenschirm 52 verändert werden kann. Ein derartiges Stellglied 174 kann beispielsweise in Form einer Schraube oder eines Schiebers ausgebildet sein.

Zur Feinabstimmung der Resonanzfrequenz der Spulenanordnung ist das zweite Ende 173 der Koppelschleife 171 über einen Abstimmkondensator 175 mit dem Außenschirm 52 verbunden. Damit ist eine Verstimmung der Resonanzfrequenz um ungefähr 2 % möglich.

Durch die Verstellung der Koppelschleife 171 mit dem Stellglied 174 wird zugleich mit der Kopplung auch der Abschlußwiderstand verändert, den die Koppelschleife 171 am Ende der koaxialen Anschlußleitung 170 bildet.

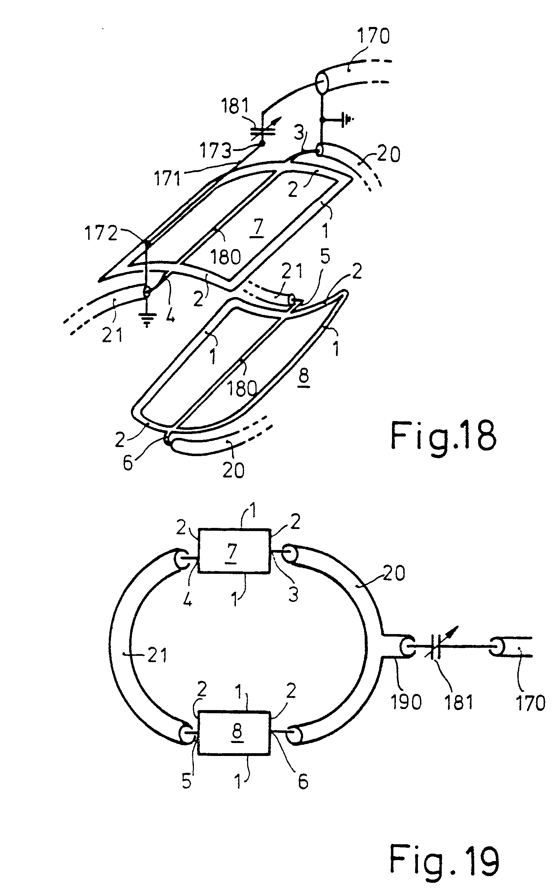

Fig. 18 zeigt schematisch in perspektivischer Darstellung eine Abwandlung der Koppelschleife 171 in mechanisch starrer Ausführung. Die magnetische Kopplung zwischen der Koppelschleife 171 und der ersten Leitergruppe 7 ist dann konstant. Die Anpassung des Abschlußwiderstandes, den die Koppelschleife 171 für die koaxiale Anschlußleitung 170 bildet, wird durch einen Abgleichkondensator 181 vorgenommen, der in Reihe zwischen dem Innenleiter der koaxialen Anschlußleitung 170 und dem zweiten Ende 173 der Koppelschleife 171 geschaltet ist. Das erste Ende 172 der Koppelschleife 171 ist wieder mit Masse, d. h. mit dem Außenschirm 52, dem Innenschirm 51 oder dem Leitermantel der koaxialen Verbindungsleitung 21 verbunden.

Zusätzlich ist zur Verstärkung der magnetischen Kopplung zwischen der Koppelschleife 171 und der ersten Leitergruppe 7 ein Hilfsleiter 180 in die Leitergruppe 7 eingefügt, der parallel zur Koppelschleife 171 angeordnet ist und an den Anschlußstellen 3 und 4 mit der Leitergruppe 7 verbunden ist. Aus Symmetriegründen ist ein gleichartiger Hilfsleiter 180 in die Leitergruppe 8 eingefügt und dort mit den Anschlußstellen 5 und 6 verbunden.

Fig. 19 zeigt ein Schema der Zusammenschaltung der Leitergruppen 7, 8 und der Verbindungsleitungen 20, 21, bei der die erste Verbindungsleitung 20 an der Stelle, an der sich im Betrieb bei der Resonanzfrequenz der Spulenanordnung ein Spannungsbauch bildet, eine Speiseanzapfung 190 aufweist, der hochfrequente elektromagnetische Energie von der Anschlußleitung 170 zugeführt wird. Ebenso dienen die Anordnungen nach Fig. 18 und 19 in gleicher Weise der Ableitung der aus dem zu messenden Körper empfangenen Relaxationssignale von der Spulenanordnung zu einer Empfangseinrichtung. In Reihe zwischen der Speiseanzapfung 190 und der Anschlußleitung 170 kann wieder ein Abgleichkondensator zum Abgleichen bzw. Anpassen der Wellenwiderstände der Anschlußleitung 170 und der ersten Verbindungsleitung 20 geschaltet sein.

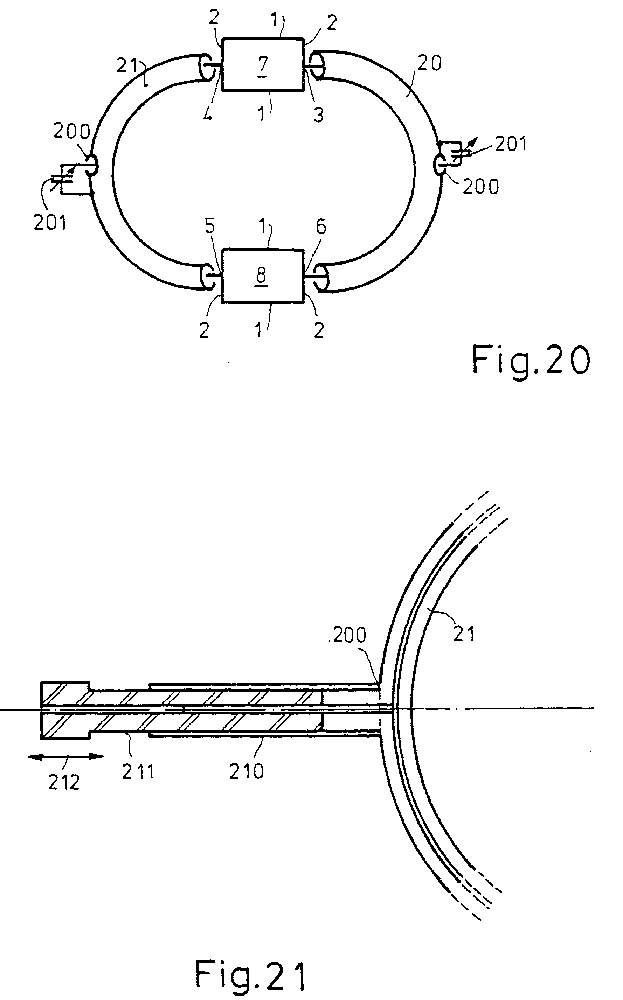

Fig. 20 zeigt eine Spulenanordnung in der Art der Darstellung nach Fig. 19, bei der die Verbindungsleitungen 20, 21 an den Stellen, an denen sich bei Resonanz auf der Spulenanordnung Spannungsbäuche bilden, mit Abstimmanzapfungen 200 versehen sind, an denen die Verbindungsleitungen durch Abstimmkondensatoren 201 überbrückt sind. Durch Verstellen der Abstimmkondensatoren 201 können die elektrischen Längen der Verbindungsleitungen 20, 21 und damit die Resonanzfrequenz der Spulenanordnung verändert werden. Aus Symmetriegründen, d. h. um die Lage der Strombäuche auf den Leitersegmenten 1 nicht zu verschieben, werden die Kapazitätswerte der Abstimmkondensatoren 201 gleich gewählt. Durch derartige Abstimmkondensatoren 201 kann eine Verschiebung der Resonanzfrequenz um über 10 % leicht erreicht werden.

Anstelle der in der Spulenanordnung nach Fig. 20 verwendeten Abstimmkondensatoren 201 können die in Fig. 21 schematisch dargestellten Abstimmleitungen 210 eingesetzt werden. Diese bestehen aus einem koaxialen Leitungsabschnitt, der ein in Längsrichtung verschiebbares Dielektrikum 211 aufweist. Durch Verschieben des Dielektrikums 211 gemäß dem Pfeil 212 wird die elektrische Länge der Abstimmleitung verstellt und damit die elektrische Länge der angeschlossenen Verbindungsleitung 20 oder 21 verändert.

Ein Ausführungsbeispiel einer Spulenanordnung, die gemäß Fig. 7 und 8 ausgeführt ist, weist einen Außenschirm 52 mit einem Durchmesser von 52 cm und einen Innenschirm 51 mit einem Durchmesser von 30 cm auf. Die Länge L1 der Leitersegmente 1 beträgt 31 cm. Die Leitersegmente sind aus Messingrohren mit einem Außendurchmesser von 4,8 mm und einer Wandstärke von 0,1 mm aufgebaut. Bei einer derartigen Dimensionierung wird die Abklingzeitkonstante für in einer Leitergruppe induzierte Wirbelströme kleiner als 0,1 msec und hat somit auf Gradientenmagnetfelder mit Frequenzen von einigen KHz keinen merklichen Einfluß mehr. Die Leitersegmente 1 sind in einem lichten Abstand von 10 mm zum Innenschirm montiert.

Die Länge L0 der Verbindungsleitungen 20, 21 beträgt bei der beschriebenen Anordnung 100 cm, es wird ein Koaxialkabel mit einem Wellenwiderstand von 50 Ohm und einer Wellenausbreitungsgeschwindigkeit von 82 % der Vakuumlichtgeschwindigkeit verwendet. Aus den vorgegebenen Abmessungen ergibt sich für den Wellenwiderstand Z1 der Leitergruppen ein Wert um 180 Ohm, die Wellenausbreitungsgeschwindigkeit entspricht der Lichtgeschwindigkeit. Die Resonanzfrequenz der Anordnung liegt bei etwa 66 MHz. Die Resonanzgüte der Spulenanordnung ohne zu messenden Körper beträgt 550 und sinkt nach Einführen eines menschlichen Kopfes auf 163. Dabei verschiebt sich die Resonanzfrequenz um nur 10 KHz, da die hochfrequenten elektrischen Felder wirksam gegenüber dem zu messenden Körper abgeschirmt sind.

## Patentansprüche

1. Hochfrequenz-Spulenanordnung zum Erzeugen und/oder Empfangen wenigstens nahezu homogener Wechselmagnetfelder, insbesondere in Kernspinresonanzgeräten, die um einen im wesentlichen zylindrischen Untersuchungsraum (13) angeordnet ist, mit wenigstens vier Leitersegmenten (1), die im wesentlichen parallel zur Längsmittelachse (9) des Untersuchungsraumes (13) und an dessen Umfang symmetrisch bezüglich wenigstens einer durch die Längsmittelachse (9) verlaufenden Ebene ausgerichtet, über Verbindungsleitungen (20, 21 ; 30, 31) zu einer in sich geschlossenen Schleife verbunden und mit die Wechselmagnetfelder hervorrufenden, hochfrequenten Strömen (I) beaufschlagbar sind, dadurch gekennzeichnet, daß die vom Strom (I) gleichsinnig bezüglich der Längsmittelachse (9) des Untersuchungsraumes zu beaufschlagenden Leitersegmente (1) an einander benachbarten Enden über im wesentlichen in Umfangsrichtung des Untersuchungsraumes (13) ausgerichtete Leiter (2) Leitergruppen (7, 8) bildend miteinander verbunden sind, daß die Leitergruppen (7, 8) miteinander über an die in Umfangsrichtung ausgerichteten Leiter (2) angeschlossene Verbindungsleitungen (20, 21 ; 30, 31) verbunden sind, und daß die Längen (L0) der Verbindungsleitungen (20, 21 ; 30, 31) derart gewählt sind, daß sich in der Mitte jedes Leitersegmentes (1) ein Amplitudenmaximum und auf jeder Verbindungsleitung (20, 21 ; 30, 31) wenigstens ein Amplitudenminimum der hochfrequenten elektrischem Ströme (I) befindet.

2. Spulenanordnung nach Anspruch 1, dadurch gekennzeichnet, daß das Verhältnis der Wellenwiderstände (Z0, Z1) einer Leitergruppe (7, 8) und einer Verbindungsleitung (20, 21) zu deren Längen (L0, L1) und Ausbreitungskonstanten (β0, β1) in der Beziehung

$$Z0/Z1 = |\tan (β0 \times L0/2) \times \tan (β1 \times L1/2)|$$

steht oder geringfügig größer ist.

3. Spulenanordnung nach Anspruch 1, dadurch gekennzeichnet, daß das Verhältnis der Wellenwiderstände (Z0, Z1) einer Leitergruppe (7, 8) und einer Verbindungsleitung (30, 31) zu deren Längen (L0, L1) und Ausbreitungskonstanten (β0, β1) in der Beziehung

$$Z0/Z1 = |\tan (β1 \times L1/2)/\tan (β0 \times L0/2)|$$

steht oder geringfügig größer ist.

4. Schaltungsanordnung nach Anspruch 1, 2 oder 3, dadurch gekennzeichnet, daß die Verbindungsleitungen (20, 21 ; 30, 31) elektrisch leitende Abschirmungen aufweisen.

5. Spulenanordnung nach einem oder mehreren der vorhergehenden Ansprüche, dadurch gekennzeichnet, daß eine Leitergruppe (7, 8) je zwei benachbarte Leitersegmente (1) umfaßt.

6. Spulenanordnung nach einem oder mehreren der vorhergehenden Ansprüche, dadurch gekennzeichnet, daß die Leitersegmente (1) in zwei symmetrisch bezüglich einer durch die Längsmittelachse (9) verlaufenden Ebene (53) ausgerichteten Leitergruppen (7, 8) angeordnet sind.

7. Spulenanordnung nach einem oder mehreren der vorhergehenden Ansprüche, dadurch gekennzeichnet, daß je zwei gleichsinnig vom Strom (I) zu beaufschlagende Leitersegmente (1) bezüglich des Untersuchungsraumes in einem Umfangswinkel (10) von wenigstens annähernd 60° angeordnet sind.

8. Spulenanordnung nach einem oder mehreren der vorhergehenden Ansprüche, dadurch gekennzeichnet, daß die Leitersegmente (1) von einer ihnen gegenüber elektrisch isoliert angebrachten, elektrisch leitenden und magnetisch durchlässigen Abschirmung (51, 52) umgeben sind.

9. Spulenanordnung nach Anspruch 8, dadurch gekennzeichnet, daß je ein in sich geschlossener Teil der elektrisch leitenden und magnetisch durchlässigen Abschirmung (51, 52) die Leitersegmente (1) je einer Leitergruppe (7, 8) gemeinsam umgibt.

10. Spulenanordnung nach Anspruch 8 oder 9, dadurch gekennzeichnet, daß die elektrisch leitende und magnetisch durchlässige Abschirmung (51, 52) einen dem Untersuchungsraum zugewandten und ihn umgebenden Innenschirm (51) und einen ihm abgewandten Außenschirm (52) umfaßt und daß Innen- (51) und Außenschirm (52) aus im wesentlichen die Form von Zylindermantelsegmenten aufweisenden Teilen aufgebaut sind.

11. Spulenanordnung nach Anspruch 10, dadurch gekennzeichnet, daß der Innenschirm (51) im Bereich der Leitersegmente (1) in Umfangsrichtung verlaufende Schlitze (60) aufweist.

12. Spulenanordnung nach Anspruch 11, dadurch gekennzeichnet, daß die Breite der Schlitze (60) in Richtung der Längsmittelachse (9) des Untersuchungsraumes von der Mitte der Spulenanordnung zu ihren Enden hin abnimmt (Fig. 10).

13. Spulenanordnung nach Anspruch 11 oder 12, dadurch gekennzeichnet, daß der Innenschirm (51) im Bereich der durch die Längsmittelachse (9) verlaufenden Ebene (53), bezüglich der die Leitergruppen (7, 8) symmetrisch ausgerichtet sind, und im Bereich der in Umfangsrichtung ausgerichteten Leiter (2) geschlossen ausgebildet ist.

14. Spulenanordnung nach einem oder mehreren der Ansprüche 10 bis 13, dadurch gekennzeichnet, daß die Verbindungsleitungen (20, 21 ; 30, 31) auf ihrer gesamten Länge in dem Bereich des Innenschirmes (51) angeordnet sind, in dem dieser geschlossen ausgebildet ist.

15. Spulenanordnung nach einem oder mehreren der Ansprüche 10 bis 14, dadurch gekennzeichnet, daß Innen- (51) und Außenschirm (52) an den Enden der Spulenanordnung durch radial angeordnete Leiterstreifen (72) miteinander verbunden sind.

16. Spulenanordnung nach einem oder mehreren der Ansprüche 10 bis 15, dadurch gekennzeichnet, daß die Abschirmung (51, 52) wenigstens teilweise schichtförmig ausgebildet ist.

17. Spulenanordnung nach einem oder mehreren der Ansprüche 10 bis 16, dadurch gekennzeichnet, daß die Abschirmung (51, 52) auf einem nichtleitenden Träger (70, 71) angeordnet ist.

18. Spulenanordnung nach einem oder mehreren der Ansprüche 10 bis 15 oder 17, dadurch gekennzeichnet, daß die Abschirmung (51, 52) netzförmig ausgebildet ist.

19. Spulenanordnung nach Anspruch 18, dadurch gekennzeichnet, daß die Abschirmung (51, 52) aus einem Drahtgeflecht aufgebaut ist.

20. Spulenanordnung nach Anspruch 16 oder 17, dadurch gekennzeichnet, daß die Abschirmung (51, 52) mit einer Schichtdicke von wenigen Skineffekt-Eindringtiefen bei der Frequenz des hochfrequenten Stromes (I) ausgeführt ist.

21. Spulenanordnung nach einem oder mehreren der vorhergehenden Ansprüche, dadurch gekennzeichnet, daß die Leitersegmente (1) und/oder die in Umfangsrichtung ausgerichteten Leiter (2) die Gestalt dünnwandiger, leitender Rohre aufweisen.

22. Spulenanordnung nach einem oder mehreren der Ansprüche 10 bis 20, dadurch gekennzeichnet, daß Außen- (52) und Innenschirm (51) im wesentlichen konzentrisch bezüglich der Längsmittelachse (9) des Untersuchungsraumes angeordnet sind.

23. Spulenanordnung nach einem oder mehreren der Ansprüche 10 bis 20, dadurch gekennzeichnet, daß die Querschnittskontur des vom Innenschirm (51) eingefaßten Untersuchungsraumes in einer zur Längsmittelachse (9) senkrechten Ebene im wesentlichen elliptisch ist.

24. Spulenanordnung nach einem oder mehreren der Ansprüche 10 bis 20 oder 23, dadurch gekennzeichnet, daß Außen- (52) und Innenschirm (51) wenigstens nahezu gleiche Krümmungsradien aufweisen.

25. Spulenanordnung nach einem oder mehreren der Ansprüche 9 bis 20 oder 22 bis 24, dadurch gekennzeichnet, daß die Abschirmung (51, 52) aus zwei in sich geschlossenen Teilen besteht, die je einen Abschirmkäfig (90, 91) mit je einem Teil des Innen- (51) und des Außenschirms (52) bilden und deren Abstand zueinander senkrecht zur Längsmittelachse (9) des Untersuchungsraumes veränderbar ist.

26. Spulenanordnung nach Anspruch 25, dadurch gekennzeichnet, daß die Abschirmkäfige (90, 91) senkrecht zur Längsmittelachse (9) des Untersuchungsraumes gegeneinander verschiebbar sind.

27. Spulenanordnung nach Anspruch 25, dadurch gekennzeichnet, daß die Abschirmkäfige (90, 91) um eine Achse (130), die in der Ebene (53), bezüglich der die Leitergruppen (7, 8) symmetrisch ausgerichtet sind, und zur Längsmittelachse (9) parallel liegt, gegeneinander verschwenkbar sind.

28. Spulenanordnung nach einem oder mehreren der vorhergehenden Ansprüche, dadurch gekennzeichnet, daß die Verbindungsleitungen (20, 21 ; 30, 31) flexibel ausgeführt sind.

29. Spulenanordnung nach einem oder mehreren der vorhergehenden Ansprüche, dadurch gekennzeichnet, daß die Leitersegmente (1) bezüglich der Längsmittelachse (9) des Untersuchungsraumes eine tonnenartige Krümmung aufweisen.

30. Spulenanordnung nach einem oder mehreren der vorhergehenden Ansprüche, dadurch gekennzeichnet, daß zusätzliche Leitungsabschnitte (160, 161) mit je einem ersten Ende mit Anschlußstellen (3, 4, 5, 6) zwischen den Verbindungsleitungen (20, 21 ; 30, 31) und den in Umfangsrichtung des Untersuchungsraumes ausgerichteten Leitern (2) verbunden sind.

31. Spulenanordnung nach Anspruch 30, dadurch gekennzeichnet, daß die zusätzlichen Leitungsabschnitte (160, 161) als an ihrem zweiten Ende leerlaufende Koaxialleitungen ausgebildet sind.

32. Spulenanordnung nach einem oder mehreren der Ansprüche 10 bis 31, dadurch gekennzeichnet, daß zwischen Innen- (51) und Außenschirm (52) im Bereich wenigstens einer Leitergruppe (7, 8) symmetrisch zu deren Leitersegmenten (1) eine elektrisch leitende Koppelschleife (171) im wesentlichen parallel zur Längsmittelachse (9) des Untersuchungsraumes angeordnet ist, die mit einem ersten Ende (172) mit dem Außenschirm (52) verbunden ist und deren zweitem Ende (173) hochfrequente elektromagnetische Energie zugeführt wird.

33. Spulenanordnung nach Anspruch 32, dadurch gekennzeichnet, daß die Koppelschleife (171) verformbar ausgeführt ist derart, daß die von der Koppelschleife (171) und dem Außenschirm (52) umgebene Fläche veränderbar ist.

34. Spulenanordnung nach Anspruch 32 oder 33, dadurch gekennzeichnet, daß parallel zur Längsmittelachse (9) des Untersuchungsraumes und an dessen Umfang und gegebenenfalls im wesentlichen parallel zur Koppelschleife (171) zu jeder Leitergruppe (7, 8) ein mit den in Umfangsrichtung ausgerichteten Leitern (2) verbundener Hilfsleiter (180) angeordnet ist.

35. Spulenanordnung nach Anspruch 32, 33 oder 34, dadurch gekennzeichnet, daß die hochfrequente elektromagnetische Energie dem zweiten Ende (173) der Koppelschleife (171) über einen einstellbaren Kondensator (181) zugeführt wird.

36. Spulenanordnung nach einem oder mehreren der Ansprüche 1 bis 31, dadurch gekennzeichnet, daß wenigstens eine der Verbindungsleitungen (20, 21 ; 30, 31) eine Speiseanzapfung (190) aufweist, über die der aus Verbindungsleitungen (20, 21 ; 30, 31) und Leitergruppen (1) gebildeten Schleife hochfrequente elektromagnetische Energie zugeführt wird.

37. Spulenanordnung nach Anspruch 36, dadurch gekennzeichnet, daß die hochfrequente elektromagnetische Energie über einen einstellbaren Kondensator (181) zugeführt wird.

38. Spulenanordnung nach einem oder mehreren der Ansprüche 32 bis 35, dadurch gekennzeichnet, daß das zweite Ende (173) der Koppelschleife (171) mit dem Außenschirm (52) über einen verstellbaren Kondensator (175) verbunden ist.

39. Spulenanordnung nach einem oder mehreren der Ansprüche 8 bis 38, dadurch gekennzeichnet, daß die Verbindungsleitungen (20, 21 ; 30, 31) je eine Abstimmanzapfung (200) aufweisen, an der sie über je einen verstellbaren Kondensator (201) mit der Abschirmung (51, 52) verbunden sind.

40. Spulenanordnung nach einem oder mehreren der Ansprüche 8 bis 38, dadurch gekennzeichnet, daß die Verbindungsleitungen (20, 21 ; 30, 31) je eine Abstimmanzapfung (200) aufweisen, an der ein erstes Ende je einer koaxialen Abstimmleitung (210) angeschlossen ist, die mit ihrem Leitermantel mit der Abschirmung (51, 52) verbunden ist und die eine verstellbare Länge aufweist.

41. Spulenanordnung nach Anspruch 40, dadurch gekennzeichnet, daß die Abstimmleitungen (210) an ihren zweiten Enden einen Leerlauf bilden und daß innerhalb der Leitermäntel je ein in Leitungslängsrichtung verschiebbares Dielektrikum (211) angeordnet ist.

**Claims**

1. A high-frequency coil system for generating and/or receiving at least substantially homogeneous alternating magnetic fields, notably in nuclear magnetic resonance apparatus, said system being arranged about an essentially cylindrical examination space (13) and comprising at least four conductor segments (1) which extend essentially parallel to the longitudinal central axis (9) of the examination space (13) and which are symmetrically oriented, at the circumference thereof, with respect to at least one plane which extends through the longitudinal central axis (9), said conductor segments being interconnected by means of connection leads (20, 21 ; 30, 31) in order to form a closed loop, characterized in that the conductor segments (1) whereto the current (I) is to be applied in the same sense with respect to the longitudinal central axis (9) of the examination space are interconnected at neighbouring ends by conductors (2) which are oriented essentially in the circumferential direction of the examination space (13) and which form conductor groups (7, 8), the conductor groups (7, 8) being interconnected by connection leads (20, 21 ; 30, 31) which are connected to the conductors (2) oriented in the circumferential direction, the lengths (L0) of the connection leads (20, 21 ; 30, 31) being chosen so that an amplitude maximum of the high-frequency currents (I) is present in the centre of each conductor segment (1) and at least one amplitude minimum thereof is present on each connection lead (20, 21 ; 30, 31).

2. A coil system as claimed in Claim 1, characterized in that the ratio of the characteristic impedances (Z0, Z1) of a conductor group (7, 8) and a connection lead (20, 21) to their lengths (L0, L1) and propagation constants ($\beta$0, $\beta$1) is in accordance with the relation

$$Z0/Z1 = |\tan(\beta0 \times L0/2) \times \tan(\beta1 \times L1/2)|$$

or is slightly higher.

3. A coil system as claimed in Claim 1, characterized in that the ratio of the characteristic impedances (Z0, Z1) of a conductor group (7, 8) and a connection lead (30, 31) to their lengths (L0, L1) and propagation constants ($\beta$0, $\beta$1) is in accordance with the relation

$$Z0/Z1 = |\tan(\beta1 \times L1/2)/\tan(\beta0 \times L0/2)|$$

or is slightly higher.

4. A circuit arrangement as claimed in Claim 1, 2 or 3, characterized in that the connection leads (20, 21 ; 30, 31) comprise electrically conductive shields.

5. A coil system as claimed in one or more of the preceding Claims, characterized in that a conductor group (7, 8) each time comprises two neighbouring conductor segments (1).

6. A coil system as claimed in one or more of the preceding Claims, characterized in that the conductor segments (1) are arranged in two conductor groups (7, 8) which are symmetrically oriented with respect to a plane (53) which extends through the central longitudinal axis (9).

7. A coil system as claimed in one or more of the preceding Claims, characterized in that every two conductor segments (1) whereto the current (I) is to be applied in the same sense are arranged so as to enclose a circumferential angle (10) of at least approximately 60° with respect to the examination space.

8. A coil system as claimed in one or more of the preceding Claims, characterized in that the conductor segments (1) are surrounded by an electrically conductive and magnetically permeable shield (51, 52) which is arranged so as to be electrically insulated from said segments.

9. A coil system as claimed in Claim 8, characterized in that a closed section of the electrically conductive and magnetically permeable shield (51, 52) each time surrounds the conductor segments (1) of one conductor group (7, 8) together.

10. A coil system as claimed in Claim 8 or 9, characterized in that the electrically conductive and magnetically permeable shield (51, 52) comprises an inner shield (51) which faces and encloses the examination space, and an outer shield (52) which is remote therefrom, the inner shield (51) and the outer shield (52) being composed of sections which are shaped essentially as cylindrical surface segments.

11. A coil system as claimed in Claim 10, characterized in that at the area of the conductor segments (1) the inner shield (51) comprises slits (60) which extend in the circumferential direction.

12. A coil system as claimed in Claim 11, characterized in that the width of the slits (60) decreases in the direction of the longitudinal central axis (9) of the examination space from the centre of the coil system towards its ends (Fig. 10).

13. A coil system as claimed in Claim 11 or 12, characterized in that the inner shield (51) is constructed so as to be closed at the area of the plane (53) which extends through the longitudinal central axis (9) and with respect to which the conductor groups (7, 8) are symmetrically arranged as well as at the area of the conductors (2) which are oriented in the circumferential direction.

14. A coil system as claimed in one or more of the Claims 10 to 13, characterized in that the connection leads (20, 21 ; 30, 31) are arranged over their entire length within the area of the inner shield (51) where the latter is constructed so as to be closed.

15. A coil system as claimed in one or more of the Claims 10 to 14, characterized in that the inner shield (51) and the outer shield (52) are interconnected at the ends of the coil system by radially arranged conductor strips (72).

16. A coil system as claimed in one or more of the Claims 10 to 15, characterized in that the shield (51, 52) has at least partly a layer construction.

17. A coil system as claimed in one or more of the Claims 10 to 16, characterized in that the shield (51, 52) is arranged on a non-conductive carrier (70, 71).

18. A coil system as claimed in one or more of the Claims 10 to 15 or 17, characterized in that the shield (51, 52) has a net-like construction.

19. A coil system as claimed in Claim 18, characterized in that the shield (51, 52) is composed of a gauze.

20. A coil system as claimed in Claim 16 or 17, characterized in that the shield (51, 52) is constructed to have a layer thickness of a few skin effect penetration depths at the frequency of the high-frequency current (I).

21. A coil system as claimed in one or more of the preceding Claims, characterized in that the conductor segments (1) and/or the conductors (2) which are oriented in the circumferential direction are constructed as thin-walled, conductive tubes.

22. A coil system as claimed in one or more of the Claims 10 to 20, characterized in that the outer shield (52) and the inner shield (51) are arranged so as to be essentially concentric with respect to the longitudinal central axis (9) of the examination space.

23. A coil system as claimed in one or more of the Claims 10 to 20, characterized in that the cross-sectional contour of the examination space enclosed by the inner shield (51) is essentially elliptical in a plane perpendicular to the longitudinal axis (9).

24. A coil system as claimed in one or more of the Claims 10 to 20 or 23, characterized in that the outer shield (52) and the inner shield (51) have at least substantially the same radius of curvature.

25. A coil system as claimed in one or more of the Claims 9 to 20 or 22 to 24, characterized in that the shield (51, 52) consists of two sections which are closed in themselves, each section forming a shielding cage (90, 91) comprising each time a part of the inner shield (51) and a part of the outer shield (52), the distance between said sections being adjustable in the direction perpendicular to the longitudinal central axis (9) of the examination space.

26. A coil system as claimed in Claim 25, characterized in that the shielding cages (90, 91) are displaceable with respect to one another in the direction perpendicular to the longitudinal central axis (9) of the examination space.

27. A coil system as claimed in Claim 25, characterized in that the shielding cages (90, 91) are arranged so as to be pivotable with respect to one another about an axis (130) which is situated in the plane (53) with respect to which the conductor groups (7, 8) are symmetrically oriented and which extends parallel to the longitudinal central axis (9).

28. A coil system as claimed in one or more of preceding Claims, characterized in that the connection leads (20, 21 ; 30, 31) are constructed so as to be flexible.

29. A coil system as claimed in one or more of the preceding Claims, characterized in that the conductor segments (1) exhibit a barrel-like curvature with respect to the longitudinal central axis (9) of the examination space.

30. A coil system as claimed in one or more of the preceding Claims, characterized in that additional lead portions (160, 161) are connected, by way of a first end, to connection terminals (3, 4, 5, 6) between the connection leads (20, 21 ; 30, 31) and the conductors (2) which are oriented in the circumferential direction of the examination space.

31. A coil system as claimed in Claim 30, characterized in that the additional lead portions (160, 161) are constructed as coaxial leads which float at their second end.

32. A coil system as claimed in one or more of the Claims 10 to 31, characterized in that an electrically conductive coupling loop (171) is arranged between the inner shield (51) and the outer shield (52) at the area of at least one conductor group (7, 8) and symmetrically with respect to the conductor segments (1) thereof, said loop extending essentially parallel to the longitudinal central axis (9) of the examination space, its first end (172) being connected to the outer shield (52) whilst its second end (173) receives high-frequency electromagnetic energy.

33. A coil system as claimed in Claim 32, characterized in that the coupling loop (171) is constructed so as to be deformable so that the surface area enclosed by the coupling loop (171) and the outer shield (52) is variable.

34. A coil system as claimed in Claim 32 or 33, characterized in that an auxiliary conductor (180) is arranged parallel to the longitudinal central axis (9) of the examination space and at the circumference thereof, and possibly essentially parallel to the coupling loop (171) to each conductor group (7, 8), said auxiliary conductor being connected to the conductors (2) which are oriented in the circumferential direction.

35. A coil system as claimed in Claim 32, 33 or 34, characterized in that the high-frequency electromagnetic energy is applied to the second end (173) of the coupling loop (171) via a variable capacitor (181).

36. A coil system as claimed in one or more of the Claims 1 to 31, characterized in that at least one of the connection leads (20, 21 ; 30, 31) comprises a supply tapping (190) via which high-frequency electromagnetic energy is applied to the loop formed by connection leads (20, 21 ; 30, 31) and conductor groups (1).

37. A coil system as claimed in Claim 36, characterized in that the high-frequency electromagnetic energy is applied via a variable capacitor (181).

38. A coil system as claimed in one or more of the Claims 32 to 35, chacterized in that the second end (173) of the coupling loop (171) is connected to the outer shield (52) via a variable capacitor (175).

39. A coil system as claimed in one or more of the Claims 8 to 38, characterized in that each of the connection leads (20, 21 ; 30, 31) comprises a tuning tapping (200) via which they are connected to the shield (51, 52) via a respective variable capacitor (201).

40. A coil system as claimed in one or more of the Claims 8 to 38, characterized in that each of the connection leads (20, 21 ; 30, 31) comprises a tuning tapping (200) whereto a first end of a respective coaxial tuning lead (210) is connected, the sheaths of said tuning leads being connected to the shield (51, 52) and their length being variable.

41. A coil system as claimed in Claim 40, characterized in that the tuning leads (210) float at their second ends, a dielectric (211) being arranged inside the sheath so as to be slidable in the longitudinal direction of the lead.

**Revendications**

1. Agencement de bobine à haute fréquence destiné à produire et/ou à recevoir des champs magnétiques alternatifs au moins à peu près homogènes, en particulier dans des appareils de résonance magnétique nucléaire, qui est disposé autour d'un espace d'examen en substance cylindrique (13), qui comprend au moins quatre segments de conducteurs (1), qui sont alignés en substance parallèlement à l'axe central longitudinal (9) de l'espace d'examen (13) et, à la périphérie de celui-ci, symétriquement par rapport à au moins un plan passant par l'axe central longitudinal (9), qui sont connectés par des lignes de connexion (20, 21 ; 30, 31) en une boucle fermée et qui peuvent être alimentés au moyen de courants de haute fréquence (I) produisant les champs magnétiques alternatifs, caractérisé en ce que les segments de conducteurs (1) à alimenter au moyen de courant (I) dans le même sens par rapport à l'axe central longitudinal (9) de l'espace d'examen sont connectés l'un à l'autre en formant des groupes de conducteurs (7, 8), à leurs extrémités voisines, par des conducteurs (2) orientés en substance dans le sens circonférentiel de l'espace d'examen (13), que les groupes de conducteurs (7, 8) sont connectés l'un à l'autre par l'intermédiaire de lignes de connexion (20, 21 ; 30, 31) connectées aux conducteurs (2) orientés dans le sens circonférentiel et que les longueurs (L0) des lignes de connexion (20, 21 ; 30, 31) sont choisies telles qu'il y ait un maximum d'amplitude des courants électriques à haute fréquence (I) au milieu de chaque segment de conducteurs (1) et au moins un minimum d'amplitude de ces courants (I) sur chaque ligne de connexion (20, 21 ; 30, 31).

2. Agencement de bobine suivant la revendication 1, caractérisé en ce que le rapport des impédances caractéristiques (Z0, Z1) d'un groupe de conducteurs (7, 8) et d'une ligne de connexion (20, 21) à leurs longueurs (L0, L1) et à leurs constantes de propagation (β0, β1) est donné par la relation suivante :

$$Z0/Z1 = |tg (\beta0 \times L0/2) \times tg (\beta1 \times L1/2)|$$

ou est un peu plus grand.

3. Agencement de bobine suivant la revendication 1, caractérisé en ce que le rapport des impédances caractéristiques (Z0, Z1) d'un groupe de conducteurs (7, 8) et d'une ligne de connexion (30, 31) à leurs longueurs (L0, L1) et à leurs constantes de propagation (β0, β1) est donné par la relation suivante :

$$Z0/Z1 = |tg (\beta1 \times L1/2) / tg (\beta0 \times L0/2)|$$

ou est un peu plus grand.

4. Agencement de bobine suivant la revendication 1, 2 ou 3, caractérisé en ce que les lignes de connexion (20, 21 ; 30, 31) comportent des blindages électriquement conducteurs.

5. Agencement de bobine suivant l'une quelconque des revendications précédentes, caractérisé en ce qu'un groupe de conducteurs (7, 8) comprend chaque fois deux segments de conducteurs (1) voisins.

6. Agencement de bobine suivant l'une quelconque des revendications précédentes, caractérisé en ce que les segments de conducteurs (1) sont disposés en deux groupes de conducteurs (7, 8) orientés symétriquement par rapport à un plan (53) passant par l'axe central longitudinal (9).

7. Agencement de bobine suivant l'une quelconque des revendications précédentes, caractérisé en ce que deux segments de conducteurs (1) à alimenter dans le même sens au moyen de courant (I) sont chaque fois disposés par rapport à l'espace d'examen selon un angle inscrit (10) d'au moins environ 60°.

8. Agencement de bobine suivant l'une quelconque des revendications précédentes, caractérisé en ce que les segments de conducteurs (1) sont entourés d'un blindage (51, 52) électriquement conducteur et magnétiquement perméable, placé sur les segments de manière à être isolé électriquement de ceux-ci.

9. Agencement de bobine suivant la revendication 8, caractérisé en ce qu'une partie fermée sur elle-même du blindage (51, 52) électriquement conducteur et magnétiquement perméable entoure chaque fois conjointement les segments de conducteurs (1) d'un groupe de conducteurs (7, 8).

10. Agencement de bobine suivant la revendication 8 ou 9, caractérisé en ce que le blindage (51, 52) électriquement conducteur et magnétiquement perméable comprend un écran intérieur (51) tourné vers l'espace d'examen et l'entourant et un écran extérieur (52) qui lui est opposé et que les écrans intérieur (51) et extérieur (52) sont constitués de pièces ayant en substance la forme de segments d'enveloppe cylindrique.

11. Agencement de bobine suivant la revendication 10, caractérisé en ce que l'écran intérieur (51) présente, dans la zone des segments de conducteurs (1), des fentes (60) qui s'étendent dans le sens circonférentiel.

12. Agencement de bobine suivant la revendication 11, caractérisé en ce que la largeur des fentes (60) va en diminuant dans le sens de l'axe central longitudinal (9) de l'espace d'examen, depuis le milieu de l'agencement de bobine vers ses extrémités (Fig. 10).

13. Agencement de bobine suivant la revendication 11 ou 12, caractérisé en ce que l'écran intérieur (51) est de configuration fermée dans la zone du plan (53) passant par l'axe central longitudinal (9) par rapport auquel les groupes de conducteurs (7, 8) sont orientés symétriquement, ainsi que dans la zone des conducteurs (2) orientés dans le sens circonférentiel.

14. Agencement de bobine suivant l'une quelconque des revendications 10 à 13, caractérisé en ce que les lignes de connexion (20, 21 ; 30, 31) sont disposées sur la totalité de leur longueur dans la zone de l'écran intérieur (51) dans laquelle celui-ci est de forme fermée.

15. Agencement de bobine suivant l'une quelconque des revendications 10 à 14, caractérisé en ce que l'écran intérieur (51) et l'écran extérieur (52) sont reliés l'un à l'autre aux extrémités de l'agencement de bobine par des bandes conductrices (72) disposées radialement.

16. Agencement de bobine suivant l'une quelconque des revendications 10 à 15, caractérisé en ce que le blindage (51, 52) est au moins partiellement en forme de couches.

17. Agencement de bobine suivant l'une quelconque des revendications 10 à 16, caractérisé en ce que le blindage (51, 52) est disposé sur un support non conducteur (70, 71).

18. Agencement de bobine suivant l'une quelconque des revendications 10 à 15 ou 17, caractérisé en ce que le blindage (51, 52) a une forme réticulée.

19. Agencement de bobine suivant la revendication 18, caractérisé en ce que le blindage (51, 52) est fait d'un treillis de fil.

20. Agencement de bobine suivant la revendication 16 ou 17, caractérisé en ce que le blindage (51, 52) est réalisé en une épaisseur de couche de quelques profondeurs de pénétration par effet pelliculaire pour la fréquence du courant à haute fréquence (I).

21. Agencement de bobine suivant l'une quelconque des revendications précédentes, caractérisé en ce que les segments de conducteurs (1) et/ou les conducteurs (2) orientés dans le sens circonférentiel ont la forme de tubes conducteurs à paroi mince.

22. Agencement de bobine suivant l'une quelconque des revendications 10 à 20, caractérisé en ce que les écrans extérieur (52) et intérieur (51) sont disposés en substance concentriquement par rapport à l'axe central longitudinal (9) de l'espace d'examen.

23. Agencement de bobine suivant l'une quelconque des revendications 10 à 20, caractérisé en ce que le contour en coupe de l'espace d'examen confiné par l'écran intérieur (51), est en substance elliptique dans un plan perpendiculaire à l'axe central longitudinal (9).

24. Agencement de bobine suivant l'une quelconque des revendications 10 à 20 ou 23, caractérisé en ce que les écrans extérieur (52) et intérieur (51) présentent des rayons de courbure au moins approximativement égaux.

25. Agencement de bobine suivant l'une quelconque des revendications 9 à 20 ou 22 à 24, caractérisé en ce que le blindage (51, 52) est formé de deux pièces fermées sur elles-mêmes qui forment chacune une cage de blindage (90, 91) avec chaque fois une partie de l'écran intérieur (51) et de l'écran extérieur (52) et dont la distance mutuelle dans le sens perpendiculaire à l'axe central longitudinal (9) de l'espace d'examen peut être modifiée.

26. Agencement de bobine suivant la revendication 25, caractérisé en ce que les cages de blindage (90, 91) peuvent être déplacées l'une par rapport à l'autre perpendiculairement à l'axe central longitudinal (9) de l'espace d'examen.

27. Agencement de bobine suivant la revendication 25, caractérisé en ce que les cages de blindage (90, 91) peuvent pivoter autour d'un axe (130) qui est disposé dans le plan (53) par rapport auquel les groupes de conducteurs (7, 8) sont orientés symétriquement et qui est parallèle à l'axe central longitudinal (9).

28. Agencement de bobine suivant l'une quelconque des revendications précédentes, caractérisé en ce que les lignes de connexion (20, 21 ; 30, 31) sont flexibles.

29. Agencement de bobine suivant l'une quelconque des revendications précédentes, caractérisé en ce que les segments de conducteurs (1) présentent une courbure en forme de baril par rapport à l'axe central longitudinal (9) de l'espace d'examen.

30. Agencement de bobine suivant l'une quelconque des revendications précédentes, caractérisé en ce que des sections de lignes supplémentaires (160, 161) sont connectées par une première extrémité à des endroits de connexion (3, 4, 5 et 6) entre les lignes de connexion (20, 21 ; 30, 31) et les conducteurs (2) orientés dans le sens circonférentiel de l'espace d'examen.

31. Agencement de bobine suivant la revendication 30, caractérisé en ce que les sections de lignes supplémentaires (160, 161) ont la forme de lignes coaxiales en circuit ouvert à leur seconde extrémité.

32. Agencement de bobine suivant l'une quelconque des revendications 10 à 31, caractérisé en ce qu'une boucle de couplage électriquement conductrice (171), qui est connectée par une première extrémité (172) à l'écran extérieur (52) et dont la seconde extrémité (173) reçoit de l'énergie électromagnétique à haute fréquence, est disposée en substance parallèlement à l'axe central longitudinal (9) de l'espace d'examen, entre l'écran intérieur (51) et l'écran extérieur (52), dans la zone d'au moins un groupe de conducteurs (7, 8), symétriquement par rapport à leurs segments de conducteurs (1).

33. Agencement de bobine suivant la revendication 32, caractérisé en ce que la boucle de couplage (171) est déformable, ce qui permet de modifier la surface entourée par la boucle de couplage (171) et l'écran extérieur (52).

34. Agencement de bobine suivant la revendication 32 ou 33, caractérisé en ce qu'un conducteur auxiliaire (180) connecté aux conducteurs (2) orientés dans le sens circonférentiel est prévu parallèlement à l'axe central longitudinal (9) de l'espace d'examen et à la périphérie de celui-ci et, le cas échéant, en substance parallèlement à la boucle de couplage (171) à chaque groupe de conducteurs (7, 8).

35. Agencement de bobine suivant la revendication 32, 33 ou 34, caractérisé en ce que l'énergie électromagnétique à haute fréquence est appliquée à la seconde extrémité (173) de la boucle de couplage (171) par l'intermédiaire d'un condensateur réglable (181).

36. Agencement de bobine suivant l'une quelconque des revendications 1 à 31, caractérisé en ce qu'au moins une des lignes de connexion (20, 21 ; 30, 31) comporte une prise d'alimentation (190) par laquelle de l'énergie électromagnétique à haute fréquence est appliquée à la boucle formée des lignes de connexion (20, 21 ; 30, 31) et des groupes de conducteurs (1).

37. Agencement de bobine suivant la revendication 36, caractérisé en ce que l'énergie électromagnétique à haute fréquence est appliquée par l'intermédiaire d'un condensateur réglable (181).

38. Agencement de bobine suivant l'une quelconque des revendications 32 à 35, caractérisé en ce que la seconde extrémité (173) de la boucle de couplage (171) est connectée à l'écran extérieur (52) par l'intermédiaire d'un condensateur réglable (175).

39. Agencement de bobine suivant l'une quelconque des revendications 8 à 38, caractérisé en ce que les lignes de connexion (20, 21 ; 30, 31) comportent chacune une prise d'accord (200) sur laquelle elles sont connectées chaque fois par l'intermédiaire d'un condensateur réglable (201) au blindage (51, 52).

40. Agencement de bobine suivant l'une quelconque des revendications 8 à 38, caractérisé en ce que les lignes de connexion (20, 21 ; 30, 31) comprennent chacune une prise d'accord (200) à laquelle une première extrémité de chaque fois une ligne d'accord coaxiale (210) est connectée, cette ligne étant connectée par sa gaine de conducteurs au blindage (51, 52) et présentant une longueur réglable.

41. Agencement de bobine suivant la revendication 40, caractérisé en ce que les lignes d'accord (210) forment un circuit ouvert à leurs secondes extrémités et qu'un diélectrique (211) déplaçable dans le sens longitudinal de la ligne est chaque fois disposé à l'intérieur des gaines de conducteurs.

Fig.1

Fig.2

Fig.3

Fig. 4

Fig.5

Fig.6

3

Fig.7

Fig.8

Fig.9

Fig.10

Fig.11

6

Fig.12

Fig.13

Fig.14

Fig.15

8

Fig.16

Fig.17

Fig.18

Fig.19

**Fig.20**

**Fig.21**